# EUROPEAN PATENT SPECIFICATION

(11) **EP 0 637 902 B1**
(45) Date of publication and mention of the grant of the patent: **31.03.1999**
(21) Application number: 94305740.6
(22) Date of filing: 03.08.1994
(51) Int. Cl.: H05K 3/38, C25D 5/48

(54) **Metallic foil with adhesion promoting layer**
Metallische Folie mit Adhäsionsverbesserungsbeschichtung
Feuille métallique à couche d'amélioration de l'adhésion

(30) Priority: 06.08.1993 US 103075
(43) Date of publication of application: 08.02.1995
(73) Proprietor: GOULD ELECTRONICS INC., Eastlake, Ohio 44095-4001 (US)
(72) Inventor: Poutasse, Charles A., III, Beachwood, Ohio 44122 (US); Kovacs, Andrea M., Bay Village, Ohio 44140 (US)
(74) Representative: Thomas, Roger Tamlyn

(56) References cited:
- DE-A- 3 208 198
- US-A- 3 508 983
- PATENT ABSTRACTS OF JAPAN vol. 14, no. 170 (E-0913) 30 March 1990 & JP-A-02 026 097 (NIKKO GURUUDE FUOIRU KK) 29 January 1990
- DATABASE WPI Derwent Publications Ltd., London, GB; AN 81-80703D & JP-A-56 118 853 (FUJITSU LTD) 18 September 1981
- DATABASE WPI Derwent Publications Ltd., London, GB; AN 83-842049 & JP-A-58 191 153 (HITACHI CHEMICAL KK) 8 November 1983

## Description

### Technical Field

This invention provides copper or copper-based alloy conductive foils having an adhesion promoting layer overlying at least one side thereof. In one embodiment these foils are used in the manufacture of printed circuit boards (PCBs). The invention thus extends to (possibly etched) laminates comprising the foils and one or more layers of non-conductive material.

### Background of the Invention

PCBs are components of electronic devices which are made from laminates which comprise a conductive foil, usually copper, and a polymeric resin substrate. The conductive foil forms the conductors in electronic devices and the polymeric resin substrate forms an insulation between the conductors. The conductor and insulator are in intimate contact and the adhesion between them contributes to the performance and reliability of the electronic devices made with them.

Electrodeposited and wrought or rolled copper foils used in the manufacture of printed circuit boards do not adhere well to the polymeric substrates. The prior practice for achieving adhesion between copper foil and insulating polymeric substrates has been to roughen the copper surface.

Surface roughening has been achieved by several means. The electrodeposited copper foils can be electroformed with a rough surface. On top of this rough surface further roughening is carried out by applying a high surface area treatment. These treatments may be a copper deposited electrolytically in nodular or dendritic form, or a copper oxide which grows nodular or dendritic. Oft times the rolled copper foil has mechanical roughness imparted to it during rolling or by subsequent abrasion. The rolled foils also are conventionally treated with surface area increasing nodular copper or copper oxide treatments.

These surface roughening treatments increase adhesion to the polymers by forming a mechanical interlock with the resin. The mechanical interlock is formed when an adhesive in its liquid state is applied and then cured or when the resin melts and flows prior to cure during lamination. The polymers flow around the roughened surface area treatments to form the mechanical interlock.

The surface roughening that has been used to enhance adhesion between copper and polymeric resin substrates cause difficulties in the manufacture of PCBs and contributes to poor PCB performance. In the subtractive copper etching process additional etching time is required to remove the dendrites or nodules embedded in the resin. This not only slows down the production process but contributes to greater line loss due to the lateral etching of the copper line's sidewalls. The surface roughening contributes to poor PCB electrical performance by slowing down high frequency electrical signals. The necessity of having a rough base foil has limited other properties, such as tensile strength and elongation, that produce good laminate and PCB performance. The dendritic or nodular surface roughening treatments are difficult to apply, requiring special equipment in the case of electrolytic treatment, and special chemicals in the case of the oxide treatments.

Japanese Patent Application Publication (Kokoku) No. 60-15654 discloses a method for adhesively attaching a chrome-treated layer of copper foil to a resin substrate. In a first embodiment the chrome-treated layer is formed on the rough or matte side of the copper foil. This chrome-treated layer is treated with a solution of a silane coupling agent represented by the formula YRSiX₃, wherein Y is a functional group that is reactive with a high polymer, R is a bonding group which includes a chain-like or a cyclic hydrocarbon connecting Y and Si, and X is a hydrolyzable organic or inorganic group. In a second embodiment the chrome-treated layer is first formed on the rough side of the copper foil and is then impregnated with a silane coupling agent represented by the above formula. With each embodiment the treated surface is bonded to the resin substrate.

Japanese Patent Application Publication (Kokoku) No. 2-19994 discloses copper foil for use in making printed circuits wherein a layer of zinc or zinc alloy is formed on the rough or matte side of the copper foil. A chrome-treated layer is formed on the zinc or zinc alloy layer. This chrome-treated layer is treated with a silane coupling agent represented by the formula YRSiX₃, wherein Y is a functional group that is reactive with a high polymer, R is a bonding group which includes a chain-like or a cyclic hydrocarbon connecting Y and Si, and X is a hydrolyzable organic or inorganic group.

US Patent 5,071,520 discloses a technique for improving the peel strength of wrought or electrolytically deposited copper foil having an anti-tarnish treatment applied thereto. The anti-tarnish treatment is applied using chromium or the combination of chromium and zinc. The treated foil is then subjected to a rinse containing a silane coupling agent.

US Patent 3,644,146 discloses a copper-clad glass epoxy laminate made with a treated copper foil sheet having an extremely thin oxidation-resistant amino-silane film applied to it. The copper foil is treated with chemicals on the bonding side to improve adhesion resulting in copper oxides being incorporated and made a part of the grain structure of the copper foil surface. The amino-silane film coats the roughened copper surface to prevent oxide transfer to the organic support and oxidation of the copper foil. The reference states that the amino-silane film can be applied to non-treated copper foil and to any other conductor metals if oxidation problems exist with such metals.

### Summary of the Invention

This invention relates to copper or copper based alloy conductive foils having a base surface on each side of said foil and an adhesion promoting layer overlying said base surface on at least one side of said foil, said adhesion promoting layer comprising at least one silane coupling agent and being free of chromium, the base surface of said foil underlying said adhesion promoting layer having an Rₜₘ surface roughness of 7 microns or less.

### Brief Description of the Drawings

In the annexed drawings, like parts and features are designated by like references:
Fig. I is a side-elevation of a copper foil with an adhesion promoting layer adhered to the matte side of said foil;
Fig. 2 is a side-elevation of a copper foil with adhesion promoting layers adhered to both the matte side and the shiny side of said foil;
Fig. 3 is a side-elevation of a copper foil with a barrier layer, stabilization layer, and adhesion promoting layer adhered to the matte side of said foil; and
Fig. 4 is a side-elevation of a copper foil with a barrier layer, stabilization layer, and adhesion promoting layer adhered to both the matte side and the shiny side of said foil.

### Description of the Preferred Embodiments

The metallic foil used with this invention is preferably an electrically conductive foil of copper or copper-based alloy. The copper foils are made using one of two techniques. Wrought or rolled copper foil is produced by mechanically reducing the thickness of a copper or copper alloy strip or ingot by a process such as rolling. Electrodeposited foil is produced by electrolytically depositing copper ions on a rotating cathode drum and then peeling the deposited strip from the cathode. Electrodeposited copper foils are especially preferred.

The copper or copper-based alloy conductive foils typically have nominal thicknesses ranging from about 0.0002 inch to about 0.02 inch (5.08 x 10⁶ - 5.08 x 10⁻⁴ m). Copper foil thickness is sometimes expressed in terms of weight and typically the foils of the present invention have weights or thicknesses ranging from about 1/8 to about 14oz/ft² (0.04 - 4.27 kg/m²). Especially useful copper foils are those having weights of ½, 1 or 2 oz/ft² (0.15, 0.30 or 0.61 kg/m²).

Electrodeposited copper foils have a smooth or shiny (drum) side and a rough or matte (copper deposit growth front) side. The adhesion promoting layer can be adhered to either side of the foil, and in some instances it is adhered to both sides.

The side or sides of the foil (electrodeposited or wrought) to which the adhesion promoting layer is adhered can be a "low-profile surface" or "very-low-profile surface. " Especially preferred embodiments involve the use of foils with very low-profile surfaces. The term "standard-profile surface" is used herein to refer to a foil surface having an Rₜₘ of about 10 microns or less. The term "low-profile surface" refers to a foil surface having an Rₜₘ of about 7 microns or less. The term "very-low-profile surface" refers to a foil surface having an Rₜₘ of about 4 microns or less. Rₜₘ is the mean of the maximum peak-to-valley vertical measurement from each of five consecutive sampling measurements, and can be measured using a Surftronic 3 profilometer marketed by Rank Taylor Hobson, Ltd., Leicester, England.

The foils of the present invention are all characterized by the absence of any added surface roughening treatment on the base surface of the side or sides to which the adhesion promoting layer is adhered. The term "base surface" of a side of foil refers to a raw foil surface which has not been subjected to any subsequent treatments of the type discussed below for refining or enhancing foil properties and/or increasing surface roughness. The term "added surface roughening" refers to any treatment performed on the base surface of the foil that increases the roughness of the surface of the foil.

The treatments that add surface roughness and are therefore excluded in accordance with the invention include copper deposited electrolytically in nodular or dendritic form, and copper oxide which grows nodular or dendritic on the base surface of the foil. Thus, the inventive foils are characterized by the absence of any dendritic or nodular copper or copper oxide applied to the base surface of the foil. (Note that copper foil having a naturally occurring, non-dendritic or non-nodular layer of copper oxide on its base surface is not excluded from being within the scope of the present invention.)

In one embodiment, mechanical roughness imparted to wrought copper foil during rolling or by subsequent abrasion which increases roughness beyond that of a low-profile surface is considered to be an added surface roughening treatment and is therefore excluded in accordance with the invention. In one embodiment, roughness imparted to an electrodeposited copper foil during electrodeposition which increases roughness beyond that of a low-profile surface is considered to be an added surface roughening. In one embodiment, any roughness imparted to the base surface of a copper foil that increases the roughness of said foil beyond that of a low-profile surface is considered to be an added surface roughening treatment. In one embodiment, any roughness imparted to the base surface of a copper foil that increases the roughness of said foil beyond that of a very low-profile surface is considered to be an added surface roughening treatment.

In one embodiment, the foils of the present invention are characterized by the absence of a metallic layer consisting of zinc or a metallic layer consisting of chromium applied to the base surface of the foil underlying the adhesion promoting layer. (Note that this limitation does not exclude the use of metallic layers comprised of mixtures of both zinc and chromium that are applied to the base surface.)

In one embodiment the base surface of the side or sides of the foil to which the adhesion promoting layer is adhered is untreated prior to the application of the adhesion promoting layer to the foil. The term "untreated" is used herein to refer to the base surface of a foil that has not undergone subsequent treatment for the purpose of refining or enhancing the foil properties and/or increasing surface roughness. In one embodiment, the untreated foils have a naturally occurring, non-dendritic or non-nodular layer of copper oxide adhered to the base surface thereof.

In one embodiment, the base surface of the side or sides of the foil to which the adhesion promoting layer is adhered is treated, prior to the application of the adhesion promoting layer, with one or more surface treatment layers for the purpose of refining or enhancing the foil properties. Any side of the foil which does not have an adhesion promoting layer applied to it can, optionally, also have one or more of such treatment layers applied to it. These surface treatments are known in the art.

The surface treatments include the application of a metallic layer to the base surface of the foil wherein the metal is selected from indium, tin, nickel, cobalt, brass, bronze, and mixtures of two or more thereof. Metallic layers of this type are sometimes referred to as barrier layers. These barrier layers preferably have thicknesses in the range of about 0.01 to about 1 micron, more preferably about 0.05 to about 0.1 micron.

The surface treatments also include the application of a metallic layer wherein the metal is tin, chromium-zinc mixture (referred to in the examples below as "Zn+Cr"), nickel, molybdenum, aluminum, or a mixture of two or more thereof. Metallic layers of this type are sometimes referred to as stabilization layers. These stabilization layers can be applied to the base surface of the foil, or they can be applied to a previously applied barrier layer. These stabilization layers preferably have thicknesses in the range of about 0.005 to about 0.05 micron, more preferably about 0.01 to about 0.02 micron.

In one embodiment, one or both sides of the foil are first treated with at least one barrier layer, then at least one of the treated sides is treated with at least one stabilization layer prior to the application of the adhesion promoting layer. The adhesion promoting layer is then applied over the stabilization layer. In this embodiment, the stabilization layer can be a layer of zinc or a layer of chromium in addition to those discussed above.

The adhesion promoting layer is adapted for enhancing adhesion between the foil and a polymeric resin substrate. The adhesion promoting layer comprises at least one silane coupling agent. In one embodiment the adhesion promoting layer is characterized by the absence of chromium intermixed therewith. The adhesion promoting layer is made by applying one or more of the following silane coupling agents to at least one side or surface of the foil.

The silane coupling agent can be represented by the formula

R₄₋ₙSiXₙ

wherein R is a functionally substituted hydrocarbon group, the functional substituent of said functionally substituted hydrocarbon group being amino, hydroxy, halo, mercapto, alkoxy, acyl, or epoxy; X is a hydrolyzable group, such as alkoxy (e.g., methoxy, ethoxy, etc.), or halogen (e.g., chlorine); and n is 1, 2 or 3, and preferably n is 3. The silane coupling agents represented by the above formula include halosilanes, aminoalkoxysilanes, aminophenylsilanes, phenylsilanes, heterocyclic silanes, N-heterocyclic silanes, acrylic silanes, mercapto silanes, and mixture of two or more thereof.

The silane coupling agent can be represented by the formula 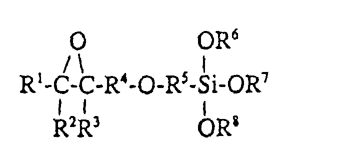 wherein: R¹, R² and R³ are each independently hydrogen or hydrocarbon groups; R⁴ and R⁵ are each independently alkylene or alkylidene groups; and R⁶, R⁷ and R⁸ are each independently hydrocarbon groups. The hydrocarbon groups preferably contain 1 to about 10 carbon atoms, more preferably 1 to about 6 carbon atoms, more preferably 1 to about 4 carbon atoms. These hydrocarbon groups are preferably alkyl. The alkylene or alkylidene groups R⁴ and R⁵ preferably contain from 1 to about 10 carbon atoms, more preferably 1 to about 6 carbon atoms, more preferably 1 to about 4 carbon atoms, more preferably 1 or 2 carbon atoms. The alkylene and alkylidene groups can be methylene, ethylene, propylene, etc. In one embodiment, the silane coupling agent is a compound represented by the formula

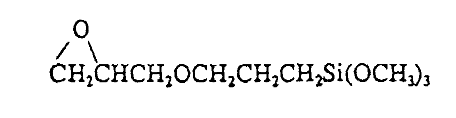

The silane coupling agent can be represented by the formula 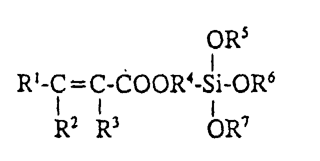 wherein: R¹, R² and R³ are each independently hydrogen or hydrocarbon groups; R⁴ is an alkylene or alkylidene group; and R⁵, R⁶ and R⁷ are each independently hydrocarbon groups. The hydrocarbon groups preferably contain 1 to about 10 carbon atoms, more preferably I to about 6 carbon atoms, more preferably 1 to about 4 carbon atoms. These hydrocarbon groups are preferably alkyl (e.g., methyl, ethyl, propyl, etc.). The alkylene and alkylidene groups preferably contain from 1 to about 10 carbon atoms, more preferably 1 to about 6 carbon atoms, more preferably 1 to about 4 carbon atoms. The alkylene groups include methylene, ethylene, propylene, etc. In one embodiment, the silane coupling agent is a compound represented by the formula

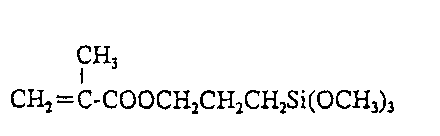

The silane coupling agent can be represented by the formula 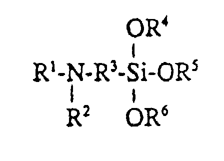 wherein: R¹ and R² are each independently hydrogen or hydrocarbon groups; R³ is an alkylene or alkylidene group; and R⁴, R⁵ and R⁶ are each independently hydrocarbon groups. The hydrocarbon groups preferably contain I to about 10 carbon atoms, more preferably 1 to about 6 carbon atoms, more preferably 1 to about 4 carbon atoms. These hydrocarbon groups are preferably alkyl (e.g., methyl, ethyl, propyl, etc.). The alkylene and alkylidene groups preferably contain from 1 to about 10 carbon atoms, more preferably 1 to about 6 carbon atoms, more preferably 1 to about 4 carbon atoms. The alkylene groups include methylene, ethylene, propylene, etc. In one embodiment this compound is represented by the formula

H₂NCH₂CH₂CH₂Si(OC₂H₅)₃

The silane coupling agent can be represented by the formula 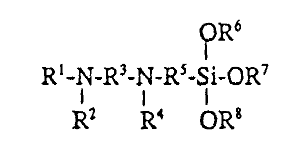 wherein: R¹, R² and R⁴ are each independently hydrogen or hydrocarbon groups; R³ and R⁵ are each independently alkylene or alkylidene groups; and R⁶, R⁷ and R⁸ are each independently hydrocarbon groups. The hydrocarbon groups preferably contain 1 to about 10 carbon atoms, more preferably 1 to about 6 carbon atoms, more preferably 1 to about 4 carbon atoms. These hydrocarbon groups are preferably alkyl (e.g., methyl, ethyl, propyl, etc.). The alkylene and alkylidene groups preferably contain from 1 to about 10 carbon atoms, more preferably 1 to about 6 carbon atoms, more preferably 1 to about 4 carbon atoms. The alkylene groups include methylene, ethylene, propylene, etc. In one embodiment this compound is represented by the formula

H₂NCH₂CH₂NHCH₂CH₂CH₂Si(OCH₃)₃

The silane coupling agent can be represented by the formula 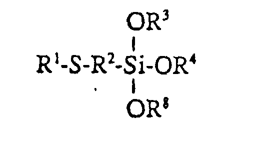 wherein R¹ is hydrogen or a hydrocarbon group; R² is an alkylene or alkylidene group; and R³, R⁴ and R⁵ are each independently hydrocarbon groups. The hydrocarbon groups preferably contain 1 to about 10 carbon atoms, more preferably 1 to about 6 carbon atoms, more preferably 1 to about 4 carbon atoms. These hydrocarbon groups are preferably alkyl (e.g., methyl, ethyl, propyl, etc.). The alkylene and alkylidene groups preferably contain from 1 to about 10 carbon atoms, more preferably 1 to about 6 carbon atoms, more preferably 1 to about 4 carbon atoms. These groups are preferably alkylene (e.g., methylene, ethylene, propylene, etc.). In one embodiment, this compound is represented by the formula

HSCH₂CH₂CH₂Si(OCH₃)₃

The silane coupling agent can be represented by the formula 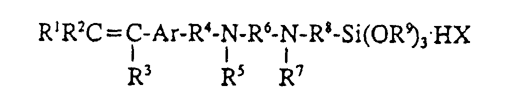 wherein: R¹, R², R³, R⁵ and R⁷ are each independently hydrogen or hydrocarbon groups; R⁴, R⁶ and R⁸ are each independently alkylene or alkylidene groups; each R⁹ is independently a hydrocarbon group; Ar is an aromatic group; and X is a halogen. The hydrocarbon groups preferably contain 1 to about 10 carbon atoms, more preferably 1 to about 6 carbon atoms, more preferably 1 to about 4 carbon atoms. These hydrocarbon groups are preferably alkyl (e.g., methyl, ethyl, propyl, etc.). The alkylene and alkylidene groups preferably contain from 1 to about 10 carbon atoms, more preferably 1 to about 6 carbon atoms, more preferably 1 to about 4 carbon atoms. These groups are preferably alkylene (e.g., methylene, ethylene, propylene, etc.). The aromatic group Ar can be mononuclear (e.g., phenylene) or polynuclear (e.g., naphthylene) with the mononuclear groups and especially phenylene being preferred. The halogen, X, is preferably chlorine or bromine, more preferably chlorine. In one embodiment this compound is represented by the formula

CH₂=CHC₆H₄CH₂NHCH₂CH₂NH(CH₂)₃Si(OCH₃)₃·HCl

The silane coupling agent can be represented by the formula 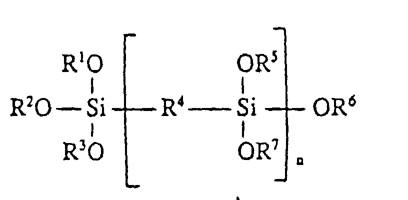 wherein R¹, R², R³, R⁵, R⁶ and R⁷ are each independently hydrocarbon groups; R⁴ is an alkylene or alkylidene group; and n is 0 or 1. The hydrocarbon groups preferably contain 1 to about 10 carbon atoms, more preferably 1 to about 6 carbon atoms, more preferably 1 to about 4 carbon atoms. These hydrocarbon groups are preferably alkyl (e.g., methyl, ethyl, propyl, etc.). The alkylene and alkylidene group preferably contains from 1 to about 10 carbon atoms, more preferably 1 to about 6 carbon atoms, more preferably 1 to about 4 carbon atoms. This group is preferably alkylene (e.g., methylene, ethylene, propylene, etc.). In one embodiment this compound is represented by the formula

(CH₃O)₃SiCH₂CH₂Si(OCH₃)₃

In one embodiment this compound is tetraethoxysilane.

Examples of useful silane coupling agents include N-(2-aminoethyl)-3-aminopropyl trimethoxysilane; 3-(N-styrylmethyl-2-aminoethylamino) propyl trimethoxysilane; 3-aminopropyl triethoxysilane; bis(2-hydroxyethyl)-3-aminopropyltriethoxysilane; β-(3,4-epoxy cyclohexyl)ethyl trimethoxysilane; 3-glycidoxypropyl trimethoxysilane; 3-methacryloxypropyl trimethoxysilane; 3-chloropropyl trimethoxysilane; vinyl trichlorosilane; vinyl triethoxysilane; vinyl-tris(2-methoxyethoxy)silane; aminopropyl trimethoxysilane; N-methylaminopropyl trimethoxysilane; and N-phenylaminopropyl trimethoxysilane.

The silane coupling agents also include 3-acetoxypropyl trimethoxysilane, N-(3-acryloxy-2-hydroxypropyl)-3-aminopropyl triethoxysilane, 3-acryloxypropyl trimethoxysilane, allyl triethoxysilane, allyl trimethoxysilane, 4-aminobutyl triethoxysilane, (aminoethylaminomethyl) phenethyl trimethoxysilane, N-(2-aminoethyl-3-aminopropyl) trimethoxysilane, N-(2-aminoethyl-3-aminopropyl) tris (2-ethylhexoxy)silane, 6(aminohexylaminopropyl) trimethoxysilane, aminophenyl trimethoxysilane, 3-(1-aminopropoxy)-3,3-dimethyl-1-propenyl trimethoxysilane, 3-aminopropyltris (methoxyethoxyethoxy) silane, 3-aminopropyl triethoxy silane, 3-aminopropyl trimethoxy silane, ω-aminoundecyl trimethoxy silane, 3-[2-N-benzylaminoethylaminopropyl] trimethoxy silane, bis(2-hydroxyethyl)-3-aminopropyl triethoxy silane, 8-bromooctyl trimethoxy silane, bromophenyl trimethoxy silane, 3-bromopropyl trimethoxy silane, 2-chloroethyl triethoxy silane, p-(chloromethyl) phenyl trimethoxy silane, chloromethyl triethoxy silane, chlorophenyl triethoxy silane, 3-chloropropyl triethoxy silane, 3-chloropropyl trimethoxy silane, 2-(4-chlorosulfonylphenyl) ethyl trimethoxy silane, 3-(cyanoethoxy)-3,3-dimethyl-1-propenyl trimethoxy silane, 2-cyanoethyl triethoxy silane, 2-cyanoethyl trimethoxy silane, (cyanomethylphenethyl) trimethoxy silane, 3-cyanopropyl triethoxy silane, 3-cyclopentadienylpropyl triethoxy silane, (N,N-diethyl-3-aminopropyl)trimethoxy silane, diethylphosphatoethyl triethoxy silane, (N,N-dimethyl-3-aminopropyl) trimethoxy silane, 2-(diphenylphosphino) ethyl triethoxy silane, 2-(3,4-epoxycyclohexyl) ethyl trimethoxy silane, 3-iodopropyl trimethoxy silane, 3-isocyanatopropyl triethoxy silane, 3-mercaptopropyl triethoxy silane, 3-mercaptopropyl trimethoxy silane, methacryloxypropenyl trimethoxy silane, 3-methacryloxypropyl trimethoxy silane, 3-methacryloxypropyltris (methoxyethoxy) silane, 3-methoxypropyl trimethoxy silane, N-methylaminopropyl trimethoxy silane, O-4-methylcoumarinyl-N-[3-(triethoxysilyl)propyl]carbamate,7-oct-1-enyltrimethoxy silane, N-phenethyl-N'-triethoxysilyl propylurea, N-phenylaminopropyl trimethoxy silane, 3-(N-styrylmethyl-2-aminoethylamino)propyl trimethoxy silane, 3-thiocyanatopropyl triethoxy silane, N-(3-triethoxysilylpropyl) acetylglycinamide, N-(triethoxysilylpropyl) dansylamide, N-[3-(triethoxysilyl)propyl]-2,4-dinitrophenylamine, triethoxysilylpropylethyl carbamate, N-[3-(triethoxysilyl)propyl]-4,5-dihydroimidazole, N-triethoxysilylpropyl-o-menthocarbamate3-(triethoxysilylpropyl)-p-nitrobenzamide, N-[3-(triethoxysilyl)propyl] phthalamic acid, N-(triethoxysilylopropyl) urea, 1-trimethoxysilyl-2-(p,m-chloromethyl)-phenylethane, 2-(trimethoxysilyl)ethylphenylsulfonylazide, β-trimethoxysilylethyl-2-pyridine, trimethoxysilyloctyl trimethylammonium bromide, trimethoxysilylpropyl cinnamate, N(3-trimethoxysilylpropyl)-N-methyl-N,N-diallylammonium chloride, trimethoxysilylpropyldiethylenetriamine, N-[(3-trimethoxysilyl)propyl] ethylenediamine triacetic acid trisodium salt, trimethoxysilylpropylisothiouronium chloride, N-(3-trimethoxysilylpropyl) pyrrole, N-trimethoxysilylpropyl tri-N-butylammonium bromide, and N-trimethoxysilylpropyl-N,N,N-trimethylammonium chloride.

The silane coupling agents also include vinyl triethoxy silane, vinyl triisopropoxy silane, vinyl trimethoxy silane, vinyl tris-t-butoxy silane, vinyl tris (2-methoxyethoxy) silane, vinyl triisopropenoxy silane, and vinyl tris (t-butylperoxy) silane.

The silane coupling agents also include 2-acetoxyethyl trichloro silane, 3-acryloxypropyl trichloro silane, allyltrichloro silane, 8-bromooctyl trichloro silane, bromophenyl trichloro silane, 3-bromopropyl trichloro silane, 2-(carbomethoxy)ethyl trichloro silane, 1-chloroethyl trichloro silane, 2-chloroethyl trichloro silane, p-(chloromethyl) phenyl trichloro silane, chloromethyl trichloro silane, chlorophenyl trichloro silane, 3-chloropropyl trichloro silane, 2-(4-chlorosulfonylphenyl) ethyl trichloro silane, (3-cyanobutyl) trichloro silane, 2-cyanoethyl trichloro silane, 3-cyanopropyl trichloro silane, (dichloromethyl) trichloro silane, (dichlorophenyl) trichloro silane, 6-hex-1-enyl trichloro silane, 3-methacryloxypropyl trichloro silane, 3-(4-methoxyphenyl)propyl trichloro silane, 7-oct-1-enyl trichloro silane, 3-(N-phthalimido) propyl trichloro silane, 1-trichlorosilyl-2-(p,m-chloromethylphenyl) ethane, 4-[2-(trichlorosilyl)ethyl] cyclohexene, 2-[2-(trichlorosilyl)ethyl] pyridine, 4-[2-(trichlorosilyl)ethyl] pyridine, 3-(trichlorosilyl)propylchloroformate, and vinyl trichloro silane.

Useful silane coupling'agents include those selected from aminopropyltrimethoxy silane, tetraethoxy silane, bis(2-hydroxyethyl)-3-aminopropyltriethoxy silane, 3-(N-styrylmethyl-2-aminoethylamine)propyltrimethoxy silane, 3-glycidoxypropyltrimethoxy silane, N-methylaminopropyltrimethoxy silane, 2-(2-aminoethyl-3-aminopropyl)trimethoxy silane, and N-phenylaminopropyltimethoxy silane.

A useful silane coupling agent mixture is 3-glycidoxypropyltrimethoxy silane and phenyltriethoxy silane. The weight ratio of the former to the latter preferably ranges from about 1:10 to about 10:1, more preferably about 1:5 to about 5:1, and in one embodiment the weight ratio is about 1:3.

A useful silane coupling agent mixture is N-methylaminopropyltrimethoxy silane and chloropropyltrimethoxy silane. The weight ratio of the former to the latter preferably ranges from about 1:10 to about 10:1, more preferably about 1:5 to about 5:1, and in one embodiment the weight ratio is about 1:1.

A useful silane coupling agent mixture is 3-(N-styrylmethyl-2-aminoethyl amino)propyltrimethoxy silane and N-methylaminopropyltrimethoxy silane. The weight ratio of the former to the latter preferably ranges from about 1:10 to about 10:1, more preferably about 1:5 to about 5:1, and in one embodiment the weight ratio is about 1:1.

A useful silane coupling agent mixture is 3-glycidoxypropyltrimethoxy silane and N-methylaminopropyltrimethoxy silane. The weight ratio of the former to the latter preferably ranges from about 1:10 to about 10:1, more preferably about 1:5 to about 5:1, and in one embodiment the weight ratio is about 1:3.

In one embodiment the silane coupling agent is other than 3-glycidoxypropyltrimethoxy silane.

The coating of the foil surface with the adhesion promoting layer may be effected by applying the silane coupling agent alone to the surface of the foil. However, it is generally preferred that coating be effected by applying the silane coupling agent in a suitable medium to the foil surface. More specifically, the silane coupling agent can be applied to the foil surface in the form of a solution in water, a mixture of water and alcohol, or a suitable organic solvent, or as an aqueous emulsion of the silane coupling agent, or as an aqueous emulsion of a solution of the silane coupling agent in a suitable organic solvent. Conventional organic solvents may be used for the silane coupling agent and include, for example, alcohols, ethers, ketones, and mixtures of these with aliphatic or aromatic hydrocarbons or with amides such as N,N-dimethylformamide. Useful solvents are those having good wetting and drying properties and include, for example, water, ethanol, isopropanol, and methylethylketone. Aqueous emulsions of the silane coupling agent may be formed in conventional manner using conventional dispersants and surfactants, including non-ionic dispersants. It may be convenient to contact the metal surface with an aqueous emulsion of the silane coupling agent The concentration of the silane coupling agent in such solutions or emulsions can be up to about 100% by weight of the silane coupling agent, but preferably is in the range of about 0.1% to about 5% by weight, more preferably about 0.3% to about 1% by weight. The process of coating with the silane coupling agent may be repeated, if desired, several times. However, a single coating step gives generally useful results. The silane coupling agent may be applied to the foil surface using known application methods which include reverse roller coating, doctor blade coating, dipping, painting and spraying.

The application of the silane coupling agent to the foil surface is typically effected at a temperature of about 15°C to about 45°C, more preferably about 20°C to about 30°C. Following application of the silane coupling agent to the foil surface, the silane coupling agent can be heated to a temperature of about 60°C to about 170°C, preferably about 90°C to 150°C, for preferably about 0.1 to about 5 minutes, more preferably about 0.2 to about 2 minutes to enhance drying of the surface. The dry film thickness of the silane coupling agent on the foil is preferably from about 0.002 to about 0.1 micron, more preferably about 0.005 to about 0.02 microns.

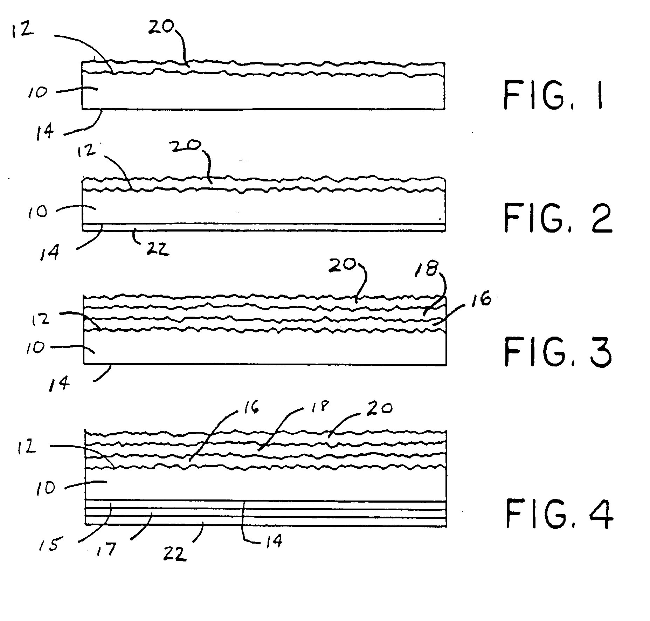

Illustrated embodiments of the inventive copper foils are disclosed in Figs. 1-4. Referring initially to Fig. 1, the inventive copper foil structure is constituted of a copper foil 10, which has a matte side 12 and a shiny side 14, and an adhesion promoting layer 20 overlying and adhered to the base surface of the matte side 12.

The structure illustrated in Fig. 2 is identical to the structure illustrated in Fig. 1, with the exception that the foil in Fig. 2 also has an adhesion promoting layer 22 overlying and adhered to the base surface of the shiny side 14 of foil 10.

Referring to Fig. 3, a copper foil 10, which has a matte side 12 and a shiny side 14, has a barrier layer 16 overlying and adhered to the base surface of the matte side 12. A stabilization layer 18 overlies and is adhered to barrier layer 16. An adhesion promoting layer 20 overlies and is adhered to the stabilization layer 18.

The structure illustrated in Fig. 4 is identical to the structure illustrated in Fig. 3, with the exception that the structure illustrated in Fig. 4 also contains a barrier layer 15 overlying and adhered to the base surface of the shiny side 14, a stabilization layer 17 overlying and adhered to the barrier layer 15, and an adhesion promoting layer 22 overlying and adhered to the stabilization layer 17.

The inventive copper foils with adhesion promoting layer applied thereto preferably have a matte-side roughness, Rₜₘ, of about 2 to about less than 7 microns, more preferably about 4 to about less than 7 microns, more preferably about 5 to about less than 7 microns. In one embodiment of the invention, these foils have weights of about ½ ounce per square foot (0.15 kg/m²) and the Rₜₘ of the matte side is preferably about 2 to about less than 7 microns, more preferably about 4 to about less than 7 microns. In one embodiment, these foils have weights of about 1 ounce per square foot (0.3 kg/m²) and the Rₜₘ of the matt side is preferably about 2 to about less than 7 microns, more preferably about 5 to about less than 7 microns. In one embodiment, these foils have weights of about 2 ounces per square foot (0.61 kg/m²) and the Rₜₘ of the matte side is preferably about 6 to less than about 7 microns. The Rₜₘ for the shiny side of these foils is preferably less than about 4 microns, more preferably less than about 3 microns, and is preferably in the range of about 1.5 to about 3 microns, more preferably in the range of about 2 to about 2.5 microns.

The following examples are provided for purposes of illustrating the invention and include comparative examples. Unless otherwise indicated, in the following examples as well as throughout the specification and claims, all parts and percentages are by weight, all temperatures are in degrees centigrade, and all pressures are atmospheric.

### Example 1

A 0.5% by weight aqueous solution of aminopropyltrimethoxy, silane in deionized water is prepared. Electrodeposited copper foil samples having weights of 1 oz/ft² (0.3 kg/m²) and the roughness (Rₜₘ) and treatment characteristics (e.g., none or untreated, stabilizer layer, barrier layer followed by stabilizer layer) indicated below are dipped in this solution for 30 seconds, squeegeed to remove excess solution from the side of interest and air dried. The samples are heated in an oven at 90±5°C for one minute to provide silane treated samples. The silane treated samples and foil samples identical to the silane treated samples but for the silane treatment are laminated to a difunctional epoxy prepreg. The samples are scribed with 1/4" (6.35x10⁻³m) lines and evaluated for initial peel strength with the following results:

| **Sample** | **Silane Treatment** | **R**_{**tm**}**(µ)** | **Barrier/Stabilizer Layer(s)** | **Initial Peel Strength (lb/inch)*** |
|---|---|---|---|---|
| A | No | 4-6 | None | 2.27 |
| B | Yes | 4-6 | None | 3.36 |
| C | No | 4-6 | Stabilizer-Zn+Cr | 3.35 |
| D | Yes | 4-6 | Stabilizer-Zn+Cr | 5.63 |
| E | No | 6-8 | Barrier-Brass/Stabilizer-Zn+Cr | 8.29, 6.17 |
| F | Yes | 6-8 | Barrier-Brass/Stabilizer-Zn+Cr | 9.89, 9.84 |
| G | No | 8-10 | Barrier-Brass/Stabilizer-Zn+Cr | 10.48 |
| H | Yes | 8-10 | Barrier-Brass/Stabilizer-Zn+Cr | 11.96 |

| | | | | |
|---|---|---|---|---|
| (*To convert to kg/m² x 2.926x10⁻⁴) | | | | |

### Example 2

A 0.5% by weight aqueous solution ofbis(2-hydroxyethyl)-3-aminopropyltriethoxysilane in deionized water is prepared. An electrodeposited copper foil sample having a weight of 1 oz/ft² and the roughness and treatment characteristics indicated below is dipped in this solution for 30 seconds, squeegeed to remove excess solution from the shiny side and air dried. The sample is heated in an oven at 90±5°C for one minute to provide a silane treated sample. The silane treated sample and a foil sample identical to the silane treated sample but for the silane treatment are laminated to a difunctional epoxy prepreg. The samples are scribed with 1/4" lines and evaluated for initial peel strength with the following results:

| **Sample** | **Silane Treatment** | **R**_{**tm**}**(µ)** | **Barrier/Stabilizer Layer(s)** | **Initial Peel Strength (lb/inch)** |
|---|---|---|---|---|
| A | No | 1-3 | Stabilizer-Zn+Cr | 2.64 |
| B | Yes | 1-3 | Stabilizer-Zn+Cr | 4.28 |

### Example 3

A 0.5% by weight aqueous solution of tetraethoxysilane in deionized water is prepared. Electrodeposited copper foil samples having weights of-1 oz/ft² and the roughness and treatment characteristics indicated below are dipped in this solution for 30 seconds, squeegeed to remove excess solution from one side and air dried. The samples are heated in an oven at 90±5°C for one minute to provide silane treated samples. The silane treated samples and foil samples identical to the silane treated samples but for the silane treatment are laminated to a difunctional epoxy prepreg. The samples are scribed with 1/4'' lines and evaluated for initial peel strength with the following results:

| **Sample** | **Silane Treatment** | **R**_{**tm**}**(µ)** | **Barrier/Stabilizer Layer(s)** | **Initial Peel Strength (lb/inch)** |
|---|---|---|---|---|
| A | No | 1-3 | Stabilizer-Zn+Cr | 3.19 |
| B | Yes | 1-3 | Stabilizer-Zn+Cr | 5.49 |
| C | No | 4-6 | Stabilizer-Zn+Cr | 3.84 |
| D | Yes | 4-6 | Stabilizer-Zn+Cr | 8.48 |
| E | No | 6-10 | Barrier-Brass/Stabilizer-Zn+Cr | 10.31 |
| F | Yes | 6-10 | Barrier-Brass/Stabilizer-Zn+Cr | 11.59 |

### Example 4

A 0.5% by weight aqueous solution of tetraethoxysilane in deionized water is prepared. Electrodeposited copper foil samples having weights of 1 oz/ft² and the roughness and treatment characteristics indicated below are dipped in this solution for 30 seconds, squeegeed to remove excess solution from one side and air dried. The samples are heated in an oven at 90±5°C for one minute to provide silane treated samples. The silane treated samples and foil samples identical to the silane treated samples but for the silane treatment are laminated to a tetrafunctional epoxy prepreg. The samples are scribed with 1/4'' lines and evaluated for initial peel strength with the following results:

| **Sample** | **Silane Treatment** | **R**_{**tm**}**(µ)** | **Barrier/Stabilizer Layer(s)** | **Initial Peel Strength (lb/inch)** |
|---|---|---|---|---|
| A | No | 1-3 | Stabilizer-Zn+Cr | 1.21 |
| B | Yes | 1-3 | Stabilizer-Zn+Cr | 4.64 |
| C | No | 4-6 | Stabilizer-Zn+Cr | 1.28 |
| D | Yes | 4-6 | Stabilizer-Zn+Cr | 6.20 |
| E | No | 6-10 | Barrier-Brass/Stabilizer-Zn+Cr | 4.71 |
| F | Yes | 6-10 | Barrier-Brass/Stabilizer-Zn+Cr | 7.13 |

### Example 5

A 0.5% by weight aqueous solution of 3-(N-styrylmethyl-2-aminoethylamine)propyltrimethoxysilane in deionized water is prepared. Electrodeposited copper foil samples having weights of 1 oz/ft² and the roughness and treatment characteristics indicated below are dipped in this solution for 30 seconds, squeegeed to remove excess solution from one side and air dried. The samples are heated in an oven at 90±5°C for one minute to provide silane treated samples. The silane treated samples and foil samples identical to the silane treated samples but for the silane treatment are laminated to a difunctional epoxy prepreg. The samples are scribed with 1/4" lines and evaluated for initial peel strength with the following results:

| **Sample** | **Silane Treatment** | **R**_{**tm**}**(µ)** | **Barrier/Stabilizer Layer(s)** | **Initial Peel Strength (lb/inch)** |
|---|---|---|---|---|
| A | No | 1-3 | Stabilizer-Zn+Cr | 2.64 |
| B | Yes | 1-3 | Stabilizer-Zn+Cr | 3.23 |
| C | No | 6-8 | Barrier-Brass/Stabilizer-Zn+Cr | 7.43 |
| D | Yes | 6-8 | Barrier-Brass/Stabilizer-Zn+Cr | 9.49 |

### Example 6

A 0.5% by weight aqueous solution of 3-glycidoxypropyltrimethoxysilane in deionized water is prepared. Electrodeposited copper foil samples having weights of 1 oz/ft² and the roughness and treatment characteristics indicated below are dipped in this solution for 30 seconds, squeegeed to remove excess solution from one side and air dried. The samples are heated in an oven at 90±5°C for one minute to provide silane treated samples. The silane treated samples and foil samples identical to the silane treated samples but for the silane treatment are laminated to a difunctional epoxy prepreg. The samples are scribed with 1/4'' lines and evaluated for initial peel strength with the following results:

| **Sample** | **Silane Treatment** | **R**_{**tm**}**(µ)** | **Barrier/Stabilizer Layer(s)** | **Initial Peel Strength (lb/inch)** |
|---|---|---|---|---|
| A | No | 4-6 | Untreated* | 4.83 |
| B | Yes | 4-6 | Untreated* | 6.36 |
| C | No | 1-3 | Stabilizer-Zn+Cr | 3.19 |
| D | Yes | 1-3 | Stabilizer-Zn+Cr | 4.55 |
| E | No | 4-6 | Stabilizer-Zn+Cr | 3.84, 3.35 |
| F | Yes | 4-6 | Stabilizer-Zn+Cr | 4.63, 7.75 |
| G | No | 6-10 | Barrier-Brass/Stabilizer-Zn+Cr | 10.31 |
| H | Yes | 6-10 | Barrier-Brass/Stabilizer-Zn+Cr | 11.67 |

| | | | | |
|---|---|---|---|---|
| * The untreated samples have a naturally occurring, non-dendritic or non-nodular layer of CuO adhered to their base surface. | | | | |

### Example 7

A 0.5% by weight aqueous solution of 3-glycidoxypropyltrimethoxy silane in deionized water is prepared. Electrodeposited copper foil samples having weights of 1 oz/ft² and the roughness and treatment characteristics indicated below are dipped in this solution for 30 seconds, squeegeed to remove excess solution from one side and air dried. The samples are heated in an oven at 90±5°C for one minute to provide silane treated samples. The silane treated samples and foil samples identical to the silane treated samples but for the silane treatment are laminated to a tetrafunctional epoxy prepreg. The samples are scribed with 1/4'' lines and evaluated for initial peel strength with the following results:

| **Sample** | **Silane Treatment** | **R**_{**tm**}**(µ)** | **Barrier/Stabilizer Layer(s)** | **Initial Peel Strength (lb/inch)** |
|---|---|---|---|---|
| A | No | 1-3 | Stabilizer-Zn+Cr | 1.21 |
| B | Yes | 1-3 | Stabilizer-Zn+Cr | 1.91 |
| C | No | 4-6 | Stabilizer-Zn+Cr | 1.28 |
| D | Yes | 4-6 | Stabilizer-Zn+Cr | 1.91 |
| E | No | 6-10 | Barrier-Brass/Stabilizer-Zn+Cr | 4.71, 5.79 |
| F | Yes | 6-10 | Barrier-Brass/Stabilizer-Zn+Cr | 7.41, 8.47 |

### Example 8

A 0.5% by weight aqueous solution of N-methylaminopropyltrimethoxysilane in deionized water is prepared. An electrodeposited copper foil sample having a weight of 1 oz/ft² and the roughness and treatment characteristics indicated below is dipped in this solution for 30 seconds, squeegeed to remove excess solution from matte side and air dried. The sample is heated in an oven at 90±5°C for one minute to provide a silane treated sample. The silane treated sample and a foil sample identical to the silane treated sample but for the silane treatment are laminated to a difunctional epoxy prepreg. The samples are scribed with 1/4'' lines and evaluated for initial peel strength with the following results:

| **Sample** | **Silane Treatment** | **R**_{**tm**}**(µ)** | **Barrier/Stabilizer Layer(s)** | **Initial Peel Strength (lb/inch)** |
|---|---|---|---|---|
| A | No | 1-3 | Stabilizer-Zn+Cr | 2.64 |
| B | Yes | 1-3 | Stabilizer-Zn+Cr | 4.21 |

### Example 9

A 0.5% by weight aqueous solution of N-(2-aminoethyl-3-aminopropyl)trimethoxysilane in deionized water is prepared. Electrodeposited copper foil samples having weights of 1 oz/ft² and the roughness and treatment characteristics indicated below are dipped in this solution for 30 seconds, squeegeed to remove excess solution from one side and air dried. The samples are heated in an oven at 90±5°C for one minute to provide silane treated samples. The silane treated samples and foil samples identical to the silane treated samples but for the silane treatment are laminated to a difunctional epoxy prepreg. The samples are scribed with 1/4'' lines and evaluated for initial peel strength with the following results:

| **Sample** | **Silane Treatment** | **R**_{**tm**}**(µ)** | **Barrier/Stabilizer Layer(s)** | **Initial Peel Strength (lb/inch)** |
|---|---|---|---|---|
| A | No | 1-3 | Stabilizer-Zn+Cr | 2.64 |
| B | Yes | 1-3 | Stabilizer-Zn+Cr | 2.72 |
| C | No | 6-8 | Barrier-Brass/Stabilizer-Zn+Cr | 6.62 |
| D | Yes | 6-8 | Barrier-Brass/Stabilizer-Zn+Cr | 9.43 |
| E | No | 8-10 | Barrier-Brass/Stabilizer-Zn+Cr | 10.17, 9.83 |
| F | Yes | 8-10 | Barrier-Brass/Stabilizer-Zn+Cr | 11.41, 11.17 |

### Example 10

A 0.5% by weight aqueous solution of N-(2-aminoethyl-3-aminopropyl)trimethoxy silane in deionized water is prepared. An electrodeposited copper foil sample having a weight of 1 oz/ft² and the roughness and treatment characteristics indicated below is dipped in this solution for 30 seconds, squeegeed to remove excess solution from the shiny side and air dried. The sample is heated in an oven at 90±5°C for one minute to provide a silane treated sample. The silane treated sample and a foil sample identical to the silane treated sample but for the silane treatment are laminated to a tetrafunctional epoxy prepreg. The samples are scribed with 1/4'' lines and evaluated for initial peel strength with the following results:

| **Sample** | **Silane Treatment** | **R**_{**tm**}**(µ)** | **Barrier/Stabilizer Layer(s)** | **Initial Peel Strength (lb/inch)** |
|---|---|---|---|---|
| A | No | 8-10 | Barrier-Brass/Stabilizer-Zn+Cr | 4.76, 4.76 |
| B | Yes | 8-10 | Barrier-Brass/Stabilizer-Zn+Cr | 6.88, 7.49 |

### Example 11

A 0.5% by weight aqueous solution of N-(2-aminoethyl-3-aminopropyl)trimethoxy silane in deionized water is prepared. An electrodeposited copper foil sample having a weight of 1 oz/ft² and the roughness and treatment characteristics indicated below is dipped in this solution for 30 seconds, squeegeed to remove excess solution from the shiny side and air dried. The sample is heated in an oven at 90±5°C for one minute to provide a silane treated sample. The silane treated sample and a foil sample identical to the silane treated sample but for the silane treatment are laminated to a multifunctional epoxy prepreg. The samples are scribed with 1/4'' lines and evaluated for initial peel strength with the following results:

| **Sample** | **Silane Treatment** | **R**_{**tm**}**(µ)** | **Barrier/Stabilizer Layer(s)** | **Initial Peel Strength (lb/inch)** |
|---|---|---|---|---|
| A | No | 8-10 | Barrier-Brass/Stabilizer-Zn+Cr | 2.41 |
| B | Yes | 8-10 | Barrier-Brass/Stabilizer-Zn+Cr | 3.33 |

### Example 12

A 0.5% by weight aqueous solution of N-phenylaminopropyltrimethoxysilane in deionized water is prepared. Electrodeposited copper foil samples having weights of 1 oz/ft² and the roughness and treatment characteristics indicated below are dipped in this solution for 30 seconds, squeegeed to remove excess solution from one side and air dried. The samples are heated in an oven at 90±5°C for one minute to provide silane treated samples. The silane treated samples and foil samples identical to the silane treated samples but for the silane treatment are laminated to a difunctional epoxy prepreg. The samples are scribed with 1/4'' lines and evaluated for initial peel strength with the following results:

| **Sample** | **Silane Treatment** | **R**_{**tm**}**(µ)** | **Barrier/Stabilizer Layer(s)** | **Initial Peel Strength (lb/inch)** |
|---|---|---|---|---|
| A | No | 1-3 | Stabilizer-Zn+Cr | 2.64 |
| B | Yes | 1-3 | Stabilizer-Zn+Cr | 3.19 |
| C | No | 6-8 | Stabilizer-Zn+Cr | 8.32 |
| D | Yes | 6-8 | Stabilizer-Zn+Cr | 9.35 |
| E | No | 6-8 | Barrier-Brass/Stabilizer-Zn+Cr | 6.77 |
| F | Yes | 6-8 | Barrier-Brass/Stabilizer-Zn+Cr | 9.07 |

### Example 13

A 0.5% by weight aqueous solution of a silane mixture in deionized water is prepared. The silane mixture is 25% by weight 3-glycidoxypropyltrimethoxysilane and 75% by weight phenyltriethoxysilane. Electrodeposited copper foil samples having weights of 1 oz/ft² and the roughness and treatment characteristics indicated below are dipped in this solution for 30 seconds, squeegeed to remove excess solution from the shiny side and air dried. The samples are heated in an oven at 90±5°C for one minute to provide silane treated samples. The silane treated samples and foil samples identical to the silane treated samples but for the silane treatment are laminated to a difunctional epoxy prepreg. The samples are scribed with 1/4'' lines and evaluated for initial peel strength with the following results:

| **Sample** | **Silane Treatment** | **R**_{**tm**}**(µ)** | **Barrier/Stabilizer Layer(s)** | **Initial Peel Strength (lb/inch)** |
|---|---|---|---|---|
| A | No | 4-6 | Untreated* | 2.52 |
| B | Yes | 4-6 | Untreated* | 3.55 |
| C | No | 4-6 -- | Stabilizer-Zn+Cr | 3.35 |
| D | Yes | 4-6 | Stabilizer-Zn+Cr | 4.69 |
| E | No | 6-8 | Stabilizer-Zn+Cr | 5.91 |
| F | Yes | 6-8 | Stabilizer-Zn+Cr | 7.81 |

| | | | | |
|---|---|---|---|---|
| * The untreated samples have a naturally occurring, non-dendritic or non-nodular layer of CuO adhered to their base surface. | | | | |

### Example 14

A 0.5% by weight aqueous solution of a silane mixture in deionized water is prepared. The silane mixture is 50% by weight N-methylaminopropyltrimethoxy silane and 50% by weight chloropropyltrimethoxy silane. Electrodeposited copper foil samples having weights of 1 oz/ft² and the roughness and treatment characteristics indicated below are dipped in this solution for 30 seconds, squeegeed to remove excess solution from the shiny side and air dried. The samples are heated in an oven at 90±5°C for one minute to provide silane treated samples. The silane treated samples and foil samples identical to the silane treated samples but for the silane treatment are laminated to a difunctional epoxy prepreg. The samples are scribed with 1/4'' lines and evaluated for initial peel strength with the following results:

| **Sample** | **Silane Treatment** | **R**_{**tm**}**(µ)** | **Barrier/Stabilizer Layer(s)** | **Initial Peel Strength (lb/inch)** |
|---|---|---|---|---|
| A | No | 6-8 | Stabilizer-Zn+Cr | 7.52 |
| B | Yes | 6-8 | Stabilizer-Zn+Cr | 9.88 |
| C | No | 6-8 | Barrier-Brass/Stabilizer-Zn+Cr | 7.43 |
| D | Yes | 6-8 | Barrier-Brass/Stabilizer-Zn+Cr | 9.85 |

### Example 15

A 0.5% by weight aqueous solution of a silane mixture in deionized water is prepared. The silane mixture is 50% by weight 3-(N-Styrylmethyl-2-aminoethylamino)propyltrimethoxy silane and 50% by weight N-methylaminopropyltrimethoxy silane. Electrodeposited copper foil samples having weights of 1 oz/ft² and the roughness and treatment characteristics indicated below are dipped in this solution for 30 seconds, squeegeed to remove excess solution from the shiny side and air dried. The samples are heated in an oven at 90±5°C for one minute to provide silane treated samples. The silane treated samples and foil samples identical to the silane treated samples but for the silane treatment are laminated to a difunctional epoxy prepreg. The samples are scribed with 1/4'' lines and evaluated for initial peel strength with the following results:

| **Sample** | **Silane Treatment** | **R**_{**tm**}**(µ)** | **Barrier/Stabilizer Layer(s)** | **Initial Peel Strength (lb/inch)** |
|---|---|---|---|---|
| A | No | 6-8 | Stabilizer-Zn+Cr | 7.52 |
| B | Yes | 6-8 | Stabilizer-Zn+Cr | 9.37 |
| C | No | 6-8 | Barrier-Brass/Stabilizer-Zn+Cr | 7.43 |
| D | Yes | 6-8 | Barrier-Brass/Stabilizer-Zn+Cr | 9.33 |

### Example 16

A 0.5% by weight aqueous solution of a silane mixture in deionized water is prepared. The silane mixture is 50% by weight 3-glycidoxypropyltrimethoxysilane and 50% by weight N-methylaminopropyltrimethoxy silane. Electrodeposited copper foil samples having weights of 1 oz/ft² and the roughness and treatment characteristics indicated below are dipped in this solution for 30 seconds, squeegeed to remove excess solution from the shiny side and air dried. The samples are heated in an oven at 90±5°C for one minute to provide silane treated samples. The silane treated samples and foil samples identical to the silane treated samples but for the silane treatment are laminated to a difunctional epoxy prepreg. The samples are scribed with 1/4" lines and evaluated for initial peel strength with the following results:

| **Sample** | **Silane Treatment** | **R**_{**tm**}**(µ)** | **Barrier/Stabilizer Layer(s)** | **Initial Peel Strength (lb/inch)** |
|---|---|---|---|---|
| A | No | 6-8 | Stabilizer-Zn+Cr | 7.52 |
| B | Yes | 6-8 | Stabilizer-Zn+Cr | 10.27 |
| C | No | 6-8 | Barrier-Brass/Stabilizer-Zn+Cr | 7.43 |
| D | Yes | 6-8 | Barrier-Brass/Stabilizer-Zn+Cr | 10.41 |

The inventive copper foils can be bonded to dielectric substrates to provide dimensional and structural stability thereto. The adhesion promoting layer of the invention enhances the bond or peel strength between the copper foil and the dielectric substrate. An advantage of the inventive copper foils is that these foils avoid added surface roughening, yet exhibit effective bond or peel strength with dielectric substrates. These foils have a low-profile surface and even a very low-profile surface, and yet provide the desired peel strength. With the inventive foils, either the matte side or shiny side can be effectively bonded to a dielectric substrate.

Useful dielectric substrates may be prepared by impregnating woven glass reinforcement materials with partially cured resins, usually epoxy resins (e.g., difunctional, tetrafunctional and multifunctional epoxies). Other useful resins include amino type resins produced from the reaction of formaldehyde and urea or formaldehyde and melamine, polyesters, phenolics, silicones, polyamides, polyimides, di-allyl phthlates, phenylsilanes, polybenizimidazoles, diphenyloxides, polytetrafluoroethylenes, cyanate esters, and the like. These dielectric substrates are sometimes referred to as prepregs.

In preparing the laminates, it is useful for both the prepreg material and the copper foil to be provided in the form of long webs of material rolled up in rolls. In one embodiment these long webs of foil and prepreg are laminated using a continuous process. In this process a continuous web of the inventive foil with the adhesion promoting layer adhered thereto is brought into contact with a continuous web of prepreg material under laminating conditions to form a laminate structure. This laminate structure is then cut into rectangular sheets and the rectangular sheets are then laid-up or assembled in stacks of assemblages.

In one embodiment the long webs of foil and prepreg material are first cut into rectangular sheets and then subjected to lamination. In this process rectangular sheets of the inventive foil with the adhesion promoting layer adhered thereto and rectangular sheets of the prepreg material are then laid-up or assembled in stacks of assemblages.

Each assemblage may comprise a prepreg sheet with a sheet of foil on either side thereof, and in each instance, the side (or one of the sides) of the copper foil sheet with the adhesion promoting layer adhered thereto is positioned adjacent the prepreg. The assemblage may be subjected to conventional laminating temperatures and pressures between the plates of laminating presses to prepare laminates comprising sandwiches of a sheet of prepreg between sheets of copper foil.

The prepregs may consist of a woven glass reinforcement fabric impregnated with a partially cured two-stage resin. By application of heat and pressure, the copper foil is pressed tightly against the prepreg and the temperature to which the assemblage is subjected activates the resin to cause curing, that is crosslinking of the resin and thus tight bonding of the foil to the prepreg dielectric substrate. Generally speaking, the laminating operation will involve pressures in the range of from about 250 to about 750 psi (1.7-5.2x10³Pa), temperatures in the range of from about 175°C to 235°C and a laminating cycle of from about 40 minutes to about 2 hours. The finished laminate may then be utilized to prepare printed circuit boards (PCB).

In one embodiment, the laminate is subjected to a subtractive copper etching process to form electrically conductive lines or an electrically conductive pattern as part of a process for making a multilayered circuit board. A second adhesion promoting layer is then applied over the etched pattern using the techniques discussed above and then a second prepreg is adhered to the etched pattern; the second adhesion promoting layer being positioned between and adhered to both the etched pattern and the second prepreg. The techniques for making multilayered circuit boards are well known in the art. Similarly, subtractive etching processes are well known, an example of which is disclosed in U.S. Patent 5,017,271.

A number of manufacturing methods are available for preparing PCBs from laminates. Additionally, there is a myriad of possible end use applications including radios, televisions, computers, etc., for the PCB's. These methods and end uses are known in the art.

An advantage of the present invention is that adhesion promoting layer not only enhances adhesion, it also provides enhanced oxidation resistance characteristics to the treated foil particularly when the shiny side of an electrodeposited copper foil is treated. This latter characteristic is of particular value due to the fact that the trend in the industry is for faster and hotter processing practices. Another advantage is that the inventive adhesion promoting layer provides enhanced acid undercutting resistance to the treated foils.

While the invention has been explained in relation to its preferred embodiments, it is to be understood that various modifications thereof within the scope of the appended claims will become apparent to those skilled in the art upon reading the specification.

## Claims

1. A copper or copper-based alloy conductive foil (10) having a base surface on each side of said foil and an adhesion promoting layer (20) overlying said base surface on at least one side of said foil,
said adhesion promoting layer (20) comprising at least one silane coupling agent and being free of chromium,
the base surface of said foil underlying said adhesion promoting layer (20) having an Rₜₘ surface roughness of 7 microns or less.

2. The foil of claim 1 wherein said foil has a matte side (12) and a shiny side (14), and said adhesion promoting layer overlies said matte side.

3. The foil of claim 1 wherein said foil has a matte side (12) and a shiny side (14), and said adhesion promoting layer overlies said shiny side.

4. The foil of claim 1, 2 or 3 wherein prior to the application of said adhesion promoting layer to said one side of said foil, said one side of said foil is untreated.

5. The foil of claim 1 wherein said adhesion promoting layer overlies both sides of said foil.

6. The foil of any preceding claim wherein said foil is an electrodeposited copper foil.

7. The foil of any one of claims 1-5 wherein said foil is a wrought copper foil.

8. The foil of any one of claims 1-7 wherein said one side of said foil has an Rₜₘ surface roughness of 4 microns or less.

9. The foil of any preceding claim wherein said silane coupling agent is at least one compound represented by the formula
**R**_{**4-n**}**SiX**_{**n**}
wherein R is a functionally substituted hydrocarbon group, the functional substituent of said functionally substituted hydrocarbon group being amino, hydroxy, halo, mercapto, alkoxy, acyl, or epoxy; X is a hydrolyzable group; and n is 1, 2 or 3.

10. The foil of any one of claims 1-8 wherein said silane coupling agent is at least one compound selected from N-(2-aminoethyl)-3-aminopropyl trimethoxy silane, 3-(N-styrylmethyl-2-aminoethylamino) propyl trimethoxy silane, 3-aminopropyl triethoxy silane, bis(2-hydroxyethyl)-3-aminopropyl triethoxy silane, β-(3,4-epoxy cyclohexyl)ethyl trimethoxy silane, 3-glycidoxypropyltrimethoxy silane, 3-methacryloxypropyl trimethoxy silane, 3-chloropropyl trimethoxy silane, vinyl trichloro silare, vinyl triethoxy silane, vinyl-tris(2-methoxyethoxy)silane, aminopropyl trimethoxy silane, N-methyl amino propyl trimethoxy silane, N-phenylaminopropyl trimethoxy silane, 3-acetoxypropyl trimethoxy silane, N-(3-acryloxy-2-hydroxypropyl)-3-aminopropyl triethoxy silane, 3-acryloxypropyl trimethoxy silane, allyl triethoxy silane, allyl trimethoxy silane, 4-aminobutyl triethoxy silane, (aminoethylaminomethyl) phenethyl trimethoxy silane, N-(2-aminoethyl-3-aminopropyl)trimethoxy silane, N-(2-aminoethyl-3-aminopropyl)tris(2-ethylhexoxy) silane, 6-(aminohexylaminopropyl) trimethoxy silane, arninophenyl trimethoxy silane, 3-(1-aminopropoxy)-3,3-dimethyl-1-propenyl trimethoxy Silane, 3-aminopropyltris (methoxyethoxyethoxy) silane, 3-aminopropyl triethoxy silane, 3-aminopropyl trimethoxy silane, ω-aminoundecyl trimethoxy silane, 3-[2-N-benzylaminoethylaminopropyl] trimethoxy silane, bis(2-hydroxyethyl)-3-aminopropyl triethoxy silane, 8-bromooctyl trimethoxy silane, bromophenyl trimethoxy silane, 3-bromopropyl trimethoxy silane, 2-chloroethyl triethoxy silane, p-(chloromethyl) phenyl trimethoxy silane, chloromethyl triethoxy silane, chlorophenyl triethoxy silane, 3-chloropropyl triethoxy silane, 3-chloropropyl trimethoxy silane, 2-(4-chlorosulfonylphenyl) ethyl trimethoxy silane, 3-(cyanoethoxy)-3,3-dimethyl-l-propenyl trimethoxy silane, 2-cyanoethyl triethoxy silane, 2-cyanoethyl trimethoxy silane, (cyanomethylphenethyl) trimethoxy silane, 3-cyanopropyl triethoxy silane, 3-cyclopentadienylpropyl triethoxy silane, (N,N-diethyl-3-aminopropyl) trimethoxy silane, diethylphosphatoethyl triethoxy silane, (N,N-dimethyl-3-aminopropyl) trimethoxy silane, 2-(diphenylphosphino) ethyl triethoxy silane, 2-(3,4-epoxycyclohexyl) ethyl trimethoxy silane, 3-iodopropyl trimethoxy silane, 3-isocyanatopropyl triethoxy silane, 3-mercaptopropyl triethoxy silane, 3-mercaptopropyl trimethoxy silane, methacryloxypropenyl trimethoxy silane, 3-methacryloxypropyl trimethoxy silane, 3-methacryloxypropyltris (methoxyethoxy) silane, 3-methoxypropyl trimethoxy silane, N-methylaminopropyl trimethoxy silane, O-4-methylcoumarinyl-N-[3-(triethoxysilyl)propyl) carbamate, 7-oct-1-enyl trimethoxy silane, N-phenethyl-N'-triethoxysilyl propylourea, N-phenylaminopropyl trimethoxy silane, 3-(N-styrylmethyl-2-aminoethylamino)propyl trimethoxy silane, 3-thiocyanatopropyl triethoxy silane, N-(3-triethoxysilylpropyl) acetylglycinamide, N-(triethoxysilylpropyl) dansylamide, N-[3-(triethoxysilyl)propyl]-2,4-dinitrophenylamine, triethoxysilylpropylethyl carbamate, N-[3-(triethoxysilyl)propyl]-4,5-dihydroimidazole ,N-triethoxysilylpropyl-o-menthocarbamate,3-(triethoxysilylpropyl)-p-nitrobenzamide, N-[3-(triethoxysilyl)propyl]phthalamic acid, N-(triethoxysilylopropyl) urea, 1-trimethoxysilyl-2-(p,m-chloromethyl)-phenylethane, 2-(trimethoxysilyl)ethylphenylsulfonylazide, β-trimethoxysilyl ethyl-2-pyridine, trimethoxysilyloctyl trimethyl ammonium bromide, trimethoxysilylpropyl cinnamate, N(3-trimethoxysilylpropyl)-N-methyl-N,N-diallylammonium chloride, trimethoxysilylpropyldiethylenetriamine, N-[(3-trimethoxysilyl)propyl] ethylenediamine triacetic acid trisodium salt, trimethoxysilylpropylisothiouronium chloride, N-(3-trimethoxysilylpropyl) pyrrole, N-trimethoxysilylpropyl tri-N-butylammonium bromide, N-trimethoxysilylpropyl-N,N,N-trimethylammonium chloride, vinyl triethoxy silane, vinyl triisopropoxy silane, vinyl trimethoxy silane, vinyl tris-t-butoxy silane, vinyl tris (2-methoxyethoxy) silane, vinyl triisopropenoxy silane, vinyl tris (t-butylperoxy) silane, 2-acetoxyethyl trichloro silane, 3-acryloxypropyl trichloro silane, allyltrichloro silane, 8-bromooctyl trichloro silane, bromophenyl trichloro silane, 3-bromopropyl trichloro silane, 2-(carbomethoxy) ethyl trichloro silane, 1-chloroethyl trichloro silane, 2-chloroethyl trichloro silane, p-(chloromethyl) phenyl trichloro silane, chloromethyl trichloro silane, chlorophenyl trichloro silane, 3-chloropropyl trichloro silane, 2-(4-chlorosulfonylphenyl) ethyl trichloro silane, (3-cyanobutyl) trichloro silane, 2-cyanoethyl trichloro silane, 3-cyanopropyl trichloro silane, (dichloromethyl) trichloro silane, (dichlorophenyl) trichloro silane, 6-hex-1-enyl trichloro silane, 3-methacryloxypropyl trichloro silane, 3-(4-methoxyphenyl)propyl trichloro silane, 7-oct-1-enyl trichloro silane, 3-(N-phthalimido) propyl trichloro silane, 1-trichlorosilyl-2-(p,m-chloromethylphenyl) ethane, 4-[2-(trichlorosilyl)ethyl] cyclohexene, 2-[2-(trichlorosilyl)ethyl] pyridine, 4-[2-(trichlorosilyl)ethyl] pyridine, 3-(trichlorosilyl)propylchloroformate, and vinyl trichloro silane.

11. The foil of any one of claims 1-8 wherein said silane coupling agent is at least one compound represented by the formula 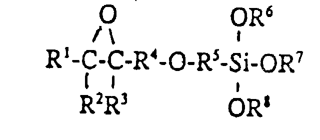 wherein:
R¹, R² and R³ are each independently hydrogen or hydrocarbon groups;
R⁴ and R⁵ are each independently alkylene or alkylidene groups; and
R⁶, R⁷ and R⁸ are each independently hydrocarbon groups.

12. The foil of any one of claims 1-8 wherein said silane coupling agent is at least one compound represented by the formula 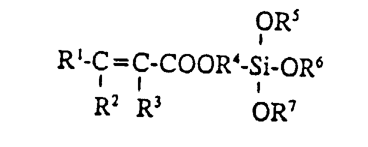 wherein:
R¹, R² and R³ are each independently hydrogen or hydrocarbon groups;
R⁴ is an alkylene or alkylidene group; and
R⁵, R⁶ and R⁷ are each independently hydrocarbon groups.

13. The foil of any one of claims 1-8 wherein said silane coupling agent is at least one compound represented by the formula 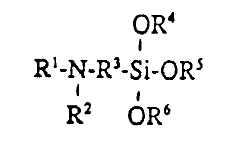 wherein:
R¹ and R² are each independently hydrogen or hydrocarbon groups;
R³ is an alkylene or alkylidene group; and
R⁴, R⁵ and R⁶ are each independently hydrocarbyl groups.

14. The foil of any one of claims 1-8 wherein said silane coupling agent is at least one compound represented by the formula 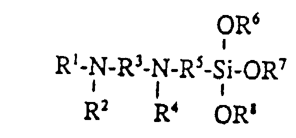 wherein:
R¹, R² and R⁴ are each independently hydrogen or hydrocarbon groups;
R³ and R⁵ are each independently alkylene or alkylidene groups; and
R⁶, R⁷ and R⁸ are each independently hydrocarbon groups.

15. The foil of any one of claims 1-8 wherein said silane coupling agent is at least one compound represented by the formula 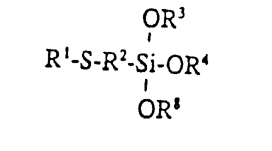 wherein:
R¹ is hydrogen or a hydrocarbon group;
R² is an alkylene or alkylidene group; and
R³, R⁴ and R⁵ are each independently hydrocarbon groups.

16. The foil of any one of claims 1-8 wherein said silane coupling agent is at least one compound represented by the formula 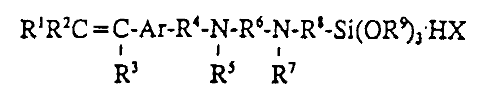 wherein:
R¹, R², R³, R⁵ and R⁷ are each independently hydrogen or hydrocarbon groups;
R⁴, R⁶ and R⁸ are each independently alkylene or alkylidene groups; and
each R⁹ is independently a hydrocarbon group;
Ar is an aromatic group; and
X is a halogen.

17. The foil of any one of claims 1-8 wherein said silane coupling agent is at least one compound represented by the formula 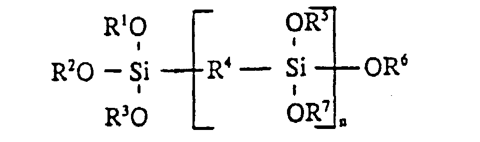 wherein
R¹, R², R³, R⁵, R⁶ and R⁷ are each independently hydrocarbon groups;
R⁴ is an alkylene or alkylidene group; and
n is 0 or 1.

18. The foil of any one of claims 1-8 wherein said silane coupling agent is selected from aminopropyltrimethoxy silane, tetraethoxy silane, bis(2-hydroxyethyl)-3-aminopropyltriethoxy silane, 3-(N-styrylmethyl-2-aminoethylamine) propyltrimethoxysilane, 3-glycidoxypropyltrimethoxysilane, N-methylaminopropyltrimethoxysilane,2-(2-aminoethyl-3-aminopropyl)trimethoxysilane, and N-phenylaminopropyltrimethoxysilane.

19. The foil of any one of claims 1-8 wherein said silane coupling agent is a mixture of silane coupling agents, said mixture being:
(A) 3-glycidoxypropyltrimethoxy silane and phenyltriethoxy silane;
(B) N-methylaminpropyltrimethoxy silane and chloropropyltrimethoxy silane;
(C) 3-(N-styrylmethyl-2-aminoethylamino)propyltrimethoxy silane and N-methylaminopropyltrimethoxy silane; or
(D) 3-glycidoxypropyltrimethoxy silane and N-methylaminopropyltrimethoxy silane.

20. The foil of any preceding claim wherein at least one metallic layer is positioned between said one side of said foil and said adhesion promoting layer, the metal in said metallic layer being selected from indium, tin, nickel, cobalt, brass, bronze or a mixture of two or more thereof.

21. The foil of any one of claims 1-19 wherein at least one metallic layer is positioned between said one side of said foil and said adhesion promoting layer, the metal in said metallic layer being selected from tin, chromium-zinc mixture, nickel, molybdenum, aluminum, and mixtures of two or more thereof.

22. The foil of any one of claims 1-19 wherein at least one first metallic layer is adhered to said one side of said foil, the metal in said first metallic layer being selected from indium, tin, nickel, cobalt, brass and bronze, at least one second metallic layer is adhered to said first metallic layer, the metal in said second metallic layer being selected from tin, chromium, chromium-zinc mixture, zinc, nickel, molybdenum, aluminum, and mixtures of two or more thereof, and said adhesion promoting layer is adhered to said second metallic layer.

23. The foil of claim 1 having a matte side and a shiny side and the adhesion promoting layer overlying said shiny side, said shiny side being untreated or being treated with at least one metallic layer consisting of indium, tin, brass, bronze, molybdenum, aluminium or a mixture of two or more thereof, said adhesion promoting layer being adhered to said untreated shiny side or said metallic layer.

24. The foil of claim 1 wherein the base surface of said foil underlying said adhesion promoting layer has at least one metallic layer adhered to it, the metal in said metallic layer being selected from indium, tin, brass, bronze or a mixture of two or more thereof, said adhesion promoting layer being adhered to said metallic layer, and wherein the foil is an electrodeposited copper foil.

25. The foil of claim 1 wherein the base surface of said foil underlying said adhesion promoting has at least one metallic layer adhered to it, the metal in said metallic layer being selected from tin, molybdenum, aluminum, and mixtures of two or more thereof, said adhesion promoting layer being adhered to said metallic layer, and wherein the foil is an electrodeposited copper foil.

26. The foil of claim 1 wherein the base surface of said foil underlying said adhesion promoting layer has at least one first metallic layer adhered to said base surface, the metal in said first metallic layer being selected from indium, tin, nickel, cobalt, brass and bronze, and at least one second metallic layer adhered to said first metallic layer, the metal in said second metallic layer being selected from tin, zinc, nickel, molybdenum, aluminum, and mixtures of two or more thereof, said adhesion promoting layer being adhered to said second metallic layer, and wherein the foil is an electrodeposited copper foil.

27. The foil of claim 1 having a low-profile surface with an Rₜₘ surface roughness of about 7 microns or less on at least one side of said foil and an adhesion promoting layer overlying said one side of said foil, the base surface of said foil being untreated or treated with at least one metallic layer consisting of indium, tin, brass, bronze, molybdenum, aluminium or a mixture of two or more thereof, said adhesion promoting layer being adhered to said untreated side of said metallic layer and wherein the foil is an electrodeposited copper foil.

28. The foil of claim 1 further comprising a layer of an electrically non-conductive material overlying the adhesion promoting layer.

## Patentansprüche

1. Leitfähige Folie (10) aus einer Kupfer- oder Kupferbasislegierung mit einer Basisoberfläche auf jeder Seite dieser Folie und einer auf dieser Basisoberfläche auf wenigstens einer Seite der Folie liegenden haftungsfördernden Schicht (20), wobei diese haftungsfördernde Schicht (20) wenigstens ein Silankupplungsmittel umfaßt und frei von Chrom ist und die unter der haftungsfördernden Schicht (20) liegende Basisoberfläche der Folie eine Oberflächenrauheit Rₜₘ von 7 µm oder weniger hat.

2. Folie nach Anspruch 1, die eine matte Seite (12) und eine glänzende Seite (14) hat, wobei die haftungsfördernde Schicht über der matten Seite liegt.

3. Folie nach Anspruch 1, die eine matte Seite (12) und eine glänzende Seite (14) hat, wobei die haftungsfördernde Schicht über der glänzenden Seite liegt.

4. Folie nach Anspruch 1, 2 oder 3, bei der vor der Aufbringung der haftungsfördernden Schicht auf einer Seite der Folie diese eine Seite der Folie unbehandelt ist.

5. Folie nach Anspruch 1, bei der die haftungsfördernde Schicht über beiden Seiten der Folie liegt.

6. Folie nach einem der vorausgehenden Ansprüche, die eine galvanisch abgeschiedene Kupferfolie ist.

7. Folie nach einem der Ansprüche 1 bis 5, die eine bearbeitete Kupferfolie ist.

8. Folie nach einem der Ansprüche 1 bis 7, bei der die eine Seite der Folie eine Oberflächenrauheit Rₜₘ von 4 µm oder weniger hat.

9. Folie nach einem der vorausgehenden Ansprüche, bei der das Silankupplungsmittel wenigstens eine Verbindung der Formel
R₄₋ₙSiXₙ
ist, worin R eine funktionell substituierte Kohlenwasserstoffgruppe ist, wobei der funktionelle Substituent der funktionell substituieren Kohlenwasserstoffgruppe Amino, Hydroxy, Halogen, Mercapto, Alkoxy, Acyl oder Epoxy ist, X eine hydrolysierbare Gruppe ist und n 1, 2 oder 3 ist.

10. Folie nach einem der Ansprüche 1 bis 8, bei der das Silankupplungsmittel wenigstens eine der folgenden Verbindungen ist: N-(2-Aminoethyl)-3-aminopropyltrimethoxysilan, 3-(N-Styrylmethyl-2-amionoethylamino)-propyltrimethoxysilan, 3-Aminopropyltriethoxysilan, Bis-(2-hydroxyethyl)-3-aminopropyltriethoxysilan, β-(3,4-Epoxycyclohexyl)-ethyltrimethoxysilan, 3-Glycidoxypropyltrimethoxysilan, 3-Methacryloxypropyltrimethoxysilan, 3-Chlorpropyltrimethoxysilan, Vinyltrichlorsilan, Vinyltriethoxysilan, Vinyltris-(2-methoxyethoxy)-silan, Aminopropyltrimethoxysilan, N-Methylaminopropyltrimethoxysilan,N-Phenylaminopropyltrimethoxysilan,3-Acetoxypropyltrimethoxysilan, N-(3-Acryloxy-2-hydroxypropyl)-3-aminopropyltriethoxysilan, 3-Acryloxypropyltrimethoxysilan, Allyltriethoxysilan, Allyltrimethoxysilan, 4-Aminobutyltriethoxysilan, (Aminoethylaminomethyl)-phenethyltrimethoxysilan, N-(2-Aminoethyl-3-aminopropyl)-tris-(2-ethylhexoxy)-silan, 6-(Aminohexylaminopropyl)-trimethoxysilan, Aminophenyltrimethoxysilan, 3-(1-Aminopropoxy)-3,3-dimethyl-1-propenyltrimethoxysilan, 3-Aminopropyl-tris-(methoxyethoxyethoxy)-silan, 3-Aminopropyltriethoxysilan, 3-Aminopropyltrimethoxysilan, w-Aminoundecyltrimethoxysilan, 3-[2-N-Benzylaminoethylaminopropyl]-trimethoxysilan,Bis-(2-hydroxyethyl)-3-aminopropyltriethoxysilan,8-Bromoctyltrimethoxysilan, Bromphenyltrimethoxysilan, 3-Brompropyltrimethoxysilan, 2-Chlorethyltriethoxysilan, p-(Chlormethyl)-phenyltrimethoxysilan, Chlormethyltriethoxysilan, Chlorphenyltriethoxysilan, 3-Chlorpropyltriethoxysilan, 3-Chlorpropyltrimethoxysilan, 2-(4-Chlorsulfonylphenyl)-ethyltrimethoxysilan, 3-(Cyanoethoxy)-3,3-dimethyl-1-propenyltrimethoxysilan, 2-Cyanoethyltriethoxysilan, 2-Cyanoethyltrimethoxysilan, (Cyanomethylphenethyl)-trimethoxysilan, 3-Cyanopropyltriethoxysilan, 3-Cyclopentadienylpropyltriethoxysilan, (N,N-Diethyl-3-aminopropyl)-trimethoxysilan, Diethylphosphatoethyltriethoxysilan, (N,N-Dimethyl-3-aminopropyl)-trimethoxysilan, 2-(Diphenylphosphino)-ethyltriethoxysilan2-(3,4-Epoxycyclohexyl)-ethyltrimethoxysilan, 3-Jodpropyltrimethoxysilan, 3-lsocyanatopropyltriethoxysilan, 3-Mercaptopropyltriethoxysilan, 3-Mercaptopropyltrimethoxysilan, Methacryloxypropenyltrimethoxysilan, 3-Methacryloxypropyltrimethoxysilan, 3-Methacryloxypropyltris-(methoxyethoxy)-silan, 3-Methoxypropyltrimethoxysilan, N-Methylaminopropyltrimethoxysilan, O-4-Methylcumarinyl-N-[3-(triethoxysilyl)-propyl]-carbamat, 7-Oct-1-enyltrimethoxysilan, N-Phenethyl-N'-triethoxysilylpropylharnstoff, N-Phenylaminopropyltrimethoxysilan,3-(N-Styrylmethyl-2-aminoethylamino)-propyltrimethoxysilan, 3-Thiocyanatopropyltriethoxysilan, N-(3-Triethoxysilylpropyl)-acetylglycinamid, N-(Triethoxysilylpropyl)-dansylamid,N-[3-(Triethoxysilyl)-propyl]-2,4-dinitrophenylamin,, Triethoxysilylpropylethylcarbamat,N-[3-(Triethoxysilyl)-propyl]-4, 5-dihydroimidazol,N-Triethoxysilylpropyl-0-menthocarbamat, 3-(Triethoxysilylpropyl)-p-nitrobenzamid, N-[3-Triethoxysilyl)-propyl]-phthalaminsäure, N-(Triethoxysilylpropyl)-harnstoff, 1-Trimethoxysilyl-2-(p,m-chlormethyl)-phenylethan, 2-(Trimethoxysilyl)-ethylphenylsulfonylazid, β-Trimethoxysilylethyl-2-pyridin, Trimethoxysilyloctyltrimethylammoniumbromid, Trimethoxysilylpropylcinnamat, N-(3-Trimethoxysilylpropyl)-N-methyl-N,N-diallylammoniumchlorid, Trimethoxysilylpropyldiethylentriamin, N-[(3-Trimethoxysilyl)-propyl]-ethylendiamintriessigsäure-Trinatriumsalz,Trimethoxysilylpropylisothiouroniumchlorid, N-(3-Trimethoxysilylpropyl)-pyrrol, N-Trimethoxysilylpropyl-tri-N-butylammoniumbromid, N-Trimethoxysilylpropyl-N,N,N-trimethylammoniumchlorid, Vinyltriethoxysilan, Vinyltriisopropoxysilan, Vinyltrimethoxysilan, Vinyl-tris-tert-butoxysilan, Vinyl-tris-(2-methoxyethoxy)-silan, Vinyltriisopropenoxysilan, Vinyl-tris-(tert-butylperoxy)-silan, 2-Acetoxyethyltrichlorsilan, 3-Acryloxypropyltrichlorsilan, Allyltrichlorsilan, 8-Bromoctyltrichlorsilan, Bromphenyltrichlorsilan, 3-Brompropyltrichlorsilan, 2-(Carbomethoxy)-ethyltrichlorsilan, 1-Chlorethyltrichlorsilan, 2-Chlorethyltrichlorsilan, p-(Chlormethyl)-phenyltrichlorsilan, Chlormethyltrichlorsilan, Chlorphenyltrichlorsilan, 3-Chlorpropyltrichlorsilan, 2-(4-Chlorsulfonylphenyl)-ethyltrichlorsilan, (3-Cyanobutyl)-trichlorsilan, 2-Cyanoethyltrichlorsilan, 3-Cyanopropyltrichlorsilan, (Dichlormethyl)-trichlorsilan, (Dichlorphenyl)-trichlorsilan, 6-Hex-1-enyltrichlorsilan, 3-Methacryloxypropyltrichlorsilan, 3-(4-Methoxyphenyl)-propyltrichlorsilan, 7-Oct-1-enyltrichlorsilan, 3-(N-Phthalimido)-propyltrichlorsilan, 1-Trichlorsilyl-2-(p,m-chlormethylphenyl)-ethan, 4-[2-(Trichlorsilyl)-ethyl]-cyclohexen, 2-[2-(Trichlorsilyl)-ethyl]-pyridin, 4-[2-(Trichlorsilyl)-ethyl]-pyridin, 3-(Trichlorsilyl)-propylchlorformiat und Vinyltrichlorsilan.

11. Folie nach einem der Ansprüche 1 bis 8, worin das Silankupplungsmittel wenigstens eine Verbindung der Formel 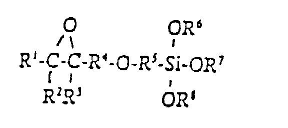 ist, worin
R¹, R² und R³ jeweils unabhängig voneinander Wasserstoff oder Kohlenwasserstoffgruppen sind,
R⁴ und R⁵ jeweils unabhängig voneinander Alkylen- oder Alkylidengruppen sind und
R⁶, R⁷ und R⁸ jeweils unabhängig voneinander Kohlenwasserstoffgruppen sind.

12. Folie nach einem der Ansprüche 1 bis 8, worin das Silankupplungsmittel wenigstens eine Verbindung der Formel 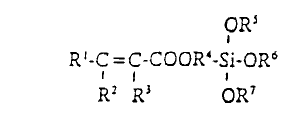 ist, worin
R¹, R² und R³ jeweils unabhängig voneinander Wasserstoff oder Kohlenwasserstoffgruppen sind,
R⁴ eine Alkylen- oder Alkylidengruppe ist und
R⁵, R⁶, R⁷ und jeweils unabhängig voneinander Kohlenwasserstoffgruppen sind.

13. Folie nach einem der Ansprüche 1 bis 8, worin das Silankupplungsmittel wenigstens eine Verbindung der Formel 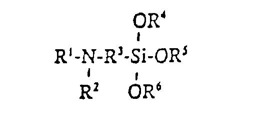 ist, worin
R¹ und R² jeweils unabhängig voneinander Wasserstoff oder Kohlenwasserstoffgruppen sind,
R³ eine Alkylen- oder Alkylidengruppe ist und
R⁴, R⁵ und R⁶ jeweils unabhängig voneinander Kohlenwasserstoffgruppen sind.

14. Folie nach einem der Ansprüche 1 bis 8, worin das Silankupplungsmittel wenigstens eine Verbindung der Formel 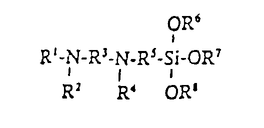 ist, worin
R¹, R² und R⁴ jeweils unabhängig voneinander Wasserstoff oder Kohlenwasserstoffgruppen sind,
R³ und R⁵ unabhängig voneinander Alkylen- oder Alkylidengruppen sind und
R⁶, R⁷ und R⁸ jeweils unabhängig voneinander Kohlenwasserstoffgruppen sind.

15. Folie nach einem der Ansprüche 1 bis 8, worin das Silankupplungsmittel wenigstens eine Verbindung der Formel 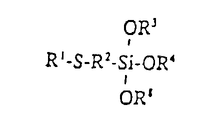 ist, worin
R¹ eine Wasserstoff- oder Kohlenwasserstoffgruppe ist,
R² eine Alkylen- oder Alkylidengruppen ist und
R³, R⁴ und R⁵ jeweils unabhängig voneinander Kohlenwasserstoffgruppen sind.

16. Folie nach einem der Ansprüche 1 bis 8, worin das Silankupplungsmittel wenigstens eine Verbindung der Formel 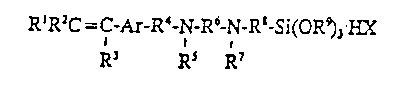 ist, worin
R¹, R², R³, R⁵ und R⁷ jeweils unabhängig voneinander Wasserstoff oder Kohlenwasserstoffgruppen sind,
R⁴, R⁶ und R⁸ jeweils unabhängig voneinander Alkylen- oder Alkylidengruppen sind und
jeweils R⁹ unabhängig voneinander eine Kohlenwasserstoffgruppe ist,
Ar eine aromatische Gruppe ist und
X ein Halogenatom ist.

17. Folie nach einem der Ansprüche 1 bis 8, worin das Silankupplungsmittel wenigstens eine Verbindung der Formel 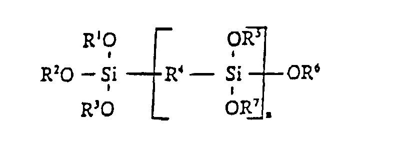 ist, worin
R¹, R², R³, R⁵, R⁶ und R⁷ jeweils unabhängig voneinander Kohlenwasserstoffgruppen sind,
R⁴ eine Alkylen- oder Alkylidengruppe ist und
R⁴, R⁵ und R⁶ jeweils unabhängig voneinander Kohlenwasserstoffgruppen sind und
n 0 oder 1 ist.

18. Folie nach einem der Ansprüche 1 bis 8, worin das Silankupplungsmittel unter Aminopropyltrimethoxysilan, Tetraethoxysilan, Bis-2-hydroxyethyl-3-aminopropyltriethoxysilan, 3-(N-Styrylmethyl-2-aminoethylamin)-propyltrimethoxysilan, 3-Glycidoxypropyltrimethoxysilan, N-Methylaminopropyltrimethoxysilan, 2-(2-Aminomethyl-3-aminopropyl)-trimethoxysilan und N-Phenylaminopropyltrimethoxysilan ausgewählt ist.

19. Folie nach einem der Ansprüche 1 bis 8, worin das Silankupplungsmittel ein Gemisch von Silankupplungsmitteln ist, wobei dieses Gemisch
A. 3-Glycidoxypropyltrimethoxysilan und Phenyltriethoxysilan,
B. N-Methylaminoproyltrimethoxysilan und Chlorpropyltrimethoxysilan,
C. 3-(N-Styrylmethyl-2-aminoethylamino)-propyltrimethoxysilan undN-Methylaminopropyltrimethoxysilan oder
D. 3-Glycidoxypropyltrimethoxysilan und N-Methylaminopropyltrimethoxysilan ist.

20. Folie nach einem der vorausgehenden Ansprüche, worin wenigstens eine Metallschicht zwischen der einen Seite der Folie und der haftungsfördernden Schicht angeordnet ist, wobei das Metall in dieser Metallschicht unter Indium, Zinn, Nickel, Kobalt, Messing, Bronze oder einem Gemisch zweier oder mehrerer hiervon ausgewählt ist.

21. Folie nach einem der Ansprüche 1 bis 19, worin wenigstens eine Metallschicht zwischen der einen Seite der Folie und der haftungsfördernden Schicht angeordnet ist, wobei das Metall in dieser Metallschicht unter Zinn, Chrom-Zink-Gemisch, Nickel, Molybdän, Aluminium und Gemischen zweier oder mehrerer hiervon ausgewählt ist.

22. Folie nach einem der Ansprüche 1 bis 19, worin wenigstens eine erste Metallschicht an einer Seite der Folie haftet, wobei das Metall in dieser ersten Metallschicht unter Indium, Zinn, Nickel, Kobalt, Messing und Bronze ausgewählt ist, wenigstens eine zweite Metallschicht an der ersten Metallschicht haftet, wobei das Metall in der zweiten Metallschicht unter Zinn, Chrom, Chrom-Zink-Gemisch, Zink, Nickel, Molybdän, Aluminium und Gemischen zweier oder mehrerer hiervon ausgewählt ist, und die haftungsfördernde Schicht an der zweiten Metallschicht haftet.

23. Folie nach Anspruch 1 mit einer matten Seite und einer glänzenden Seite, wobei die haftungsfördernde Schicht über der glänzenden Seite liegt, die glänzende Seite unbehandelt ist oder mit wenigstens einer Metallschicht behandelt ist, die aus Indium, Zinn, Messing, Bronze, Molybdän, Aluminium oder einem Gemisch zweier oder mehrerer hiervon besteht, und die haftungsfördernde Schicht an der unbehandelten glänzenden Schicht oder der Metallschicht haftet.

24. Folie nach Anspruch 1, bei der die Basisoberfläche der Folie, die unter der haftungsfördernden Schicht liegt, wenigstens eine Metallschicht hat, die an ihr haftet, wobei das Metall in dieser Metallschicht unter Indium, Zinn, Messing, Bronze oder einem Gemisch zweier oder mehrerer hiervon ausgewählt ist, die haftungsfördernde Schicht an der Metallschicht haftet und die Folie eine galvanisch abgeschiedene Kupferfolie ist.

25. Folie nach Anspruch 1, bei der die Basisoberfläche der Folie, die unter der haftungsfördernden Schicht liegt, wenigstens eine Metallschicht hat, die an ihr haftet, wobei das Metall in der Metallschicht unter Zinn, Molybdän, Aluminium und Gemischen zweier oder mehrerer hiervon ausgewählt ist, die haftungsfördernde Schicht an der Metallschicht haftet und die Folie eine galvanisch abgeschiedene Kupferfolie ist.

26. Folie nach Anspruch 1, worin die Basisoberfläche der Folie, die unter der haftungsfördernden Schicht liegt, wenigstens eine erste Metallschicht hat, die an der Basis- oberfläche haftet, wobei das Metall in dieser ersten Metallschicht unter Indium, Zinn, Nickel, Kobalt, Messing und Bronze ausgewählt ist, und wenigstens eine zweite Metallschicht hat, die an der ersten Metallschicht haftet, wobei das Metall in der zweiten Metallschicht unter Zinn, Zink, Nickel, Molybdän, Aluminium und Gemischen zweier oder mehrerer hiervon ausgewählt ist und wobei die haftungsfördernde Schicht an der zweiten Metallschicht haftet, und die Folie eine galvanisch abgeschiedene Kupferfolie ist.

27. Folie nach Anspruch 1 mit einer Oberfläche mit niedrigem Profil mit einer Oberflächenrauheit Rₜₘ von etwa 7 um oder weniger auf wenigstens einer Seite der Folie und einer haftungsfördernden Schicht, die über dieser einen Seite der Folie liegt, wobei die Basisoberfläche der Folie unbehandelt ist oder mit wenigstens einer Metallschicht behandelt ist, die aus Indium, Zinn, Messing, Bronze, Molybdän, Aluminium oder einem Gemisch zweier oder mehrerer hiervon besteht, die haftungsfördernde Schicht an der unbehandelten Seite der Metallschicht haftet und die Folie eine galvanisch abgeschiedene Kupferfolie ist.

28. Folie nach Anspruch 1 weiterhin mit einer Schicht eines elektrisch nichtleitenden Materials, die über der haftungsfördernden Schicht liegt.

## Revendications

1. Feuille métallique conductrice (10) en cuivre ou à base d'alliage de cuivre ayant une surface de base de chaque côté de ladite feuille métallique et une couche (20) favorisant l'adhérence qui recouvre ladite surface de base d'au moins un côté de ladite feuille métallique,
ladite couche (20) favorisant l'adhérence comprenant au moins un agent de couplage du type silane et étant exempte de chrome,
la surface de base de ladite feuille métallique, qui est située au-dessous de ladite couche (20) favorisant l'adhérence, ayant une rugosité superficielle Rₜₘ de 7 micromètres ou moins.

2. Feuille métallique selon la revendication 1, ladite feuille métallique ayant un côté mat (12) et un côté brillant (14), dans laquelle ladite couche favorisant l'adhérence recouvre ledit côté mat.

3. Feuille métallique selon la revendication 1, ladite feuille métallique ayant un côté mat (12) et un côté brillant (14), dans laquelle ladite couche favorisant l'adhérence recouvre ledit côté brillant.

4. Feuille métallique selon la revendication 1, 2 ou 3, dans laquelle, avant l'application de ladite couche favorisant l'adhérence sur ledit côté de ladite feuille métallique, ledit côté de ladite feuille métallique est non traité.

5. Feuille métallique selon la revendication 1, dans laquelle ladite couche favorisant l'adhérence recouvre les deux côtés de ladite feuille métallique.

6. Feuille métallique selon l'une quelconque des revendications précédentes, ladite feuille métallique étant une feuille de cuivre déposée par électrolyse.

7. Feuille métallique selon l'une quelconque des revendications 1 à 5, ladite feuille métallique étant une feuille de cuivre battu.

8. Feuille métallique selon l'une quelconque des revendications 1 à 7, dans laquelle ledit côté de ladite feuille métallique a une rugosité superficielle Rₜₘ de 4 micromètres ou moins.

9. Feuille métallique selon l'une quelconque des revendications précédentes, dans laquelle ledit agent de couplage du type silane est au moins un composé représenté par la formule
R₄₋ₙSiXₙ
dans laquelle R est un groupe hydrocarbure à fonctionnalité substituée, le substituant fonctionnel dudit groupe hydrocarbure à fonctionnalité substituée étant un groupe amino, hydroxy, halogéno, mercapto, alkoxy, acyle ou époxy ; X est un groupe hydrolysable ; et n vaut 1, 2 ou 3.

10. Feuille métallique selon l'une quelconque des revendications 1 à 8, dans laquelle ledit agent de couplage du type silane est au moins un composé choisi parmi : N-(2-aminoéthyl)-3-aminopropyltriméthoxysilane, 3-(N-styrylméthyl-2-aminoéthylamino)propyltriméthoxysilane, 3-aminopropyltriéthoxysilane, bis(2-hydroxyéthyl)-3-aminopropyltriéthoxysilane, 1-(3,4-époxycyclohexyl)éthyltriméthoxysilane, 3-glycidoxypropyltriméthoxysilane, 3-méthacryloxypropyltriméthoxysilane, 3-chloropropyltriméthoxysilane, vinyltrichlorosilane, vinyltriéthoxysilane, vinyl-tris(2-méthoxyéthoxy)silane, aminopropyltriméthoxysilane, N-méthylaminopropyltriméthoxysilane, N-phénylaminopropyltriméthoxysilane, 3-acétoxypropyltriméthoxysilane, N-(3-acryloxy-2-hydroxypropyl)-3-aminopropyltriéthoxysilane, 3-acryloxytriméthoxysilane, allyltriéthoxysilane, allyltriméthoxysilane, 4-aminobutyltriéthoxysilane, (aminoéthylaminométhyl)phénéthyltriméthoxysilane, N-(2-aminoéthyl-3-aminopropyl)triméthoxysilane, N-(2-aminoéthyl-3-aminopropyl)tris(2-éthylhexoxy)silane, 6-(aminohexylaminopropyl)triméthoxysilane, aminophényltriméthoxysilane, 3-(1-aminopropoxy)-3,3-diméthyl-1-propényltriméthoxysilane, 3-aminopropyltris(méthoxyéthoxyéthoxy)silane, 3-aminopropyltriéthoxysilane, 3-aminopropyltriméthoxysilane, ω-aminoundécyltriméthoxysilane, 3-[2-N-benzylaminoéthylaminopropyl]triméthoxysilane, bis(2-hydroxyéthyl)-3-aminopropyltriéthoxysilane, 8-bromooctyltriméthoxysilane, bromophényltriméthoxysilane, 3-bromopropyltriméthoxysilane, 2-chloroéthyltriéthoxysilane, p-(chlorométhyl)phényltriméthoxysilane, chlorométhyltriéthoxysilane, chlorophényltriéthoxysilane, 3-chloropropyltriéthoxysilane, 3-chloropropyltriméthoxysilane, 2-(4-chlorosulfonylphényl)éthyltriméthoxysilane, 3-(cyanoéthoxy)-3,3-diméthyl-1-propényltriméthoxysilane, 2-cyanoéthyltriéthoxysilane, 2-cyanoéthyltriméthoxysilane, (cyanométhylphénéthyl)triméthoxysilane, 3-cyanopropyltriéthoxysilane, 3-cyclopentadiénylpropyltriéthoxysilane, (N,N-diéthyl-3-aminopropyl)triméthoxysilane, diéthylphosphatoéthyltriéthoxysilane, (N,N-diméthyl-3-aminopropyl)triméthoxysilane, 2-(diphénylphosphino)éthyltriéthoxysilane, 2-(3,4-époxycyclohexyl)éthyltriméthoxysilane, 3-iodopropyltriméthoxysilane, 3-isocyanatopropyltriéthoxysilane, 3-mercaptopropyltriéthoxysilane, 3-mercaptopropyltriméthoxysilane, méthacryloxypropényltriméthoxysilane, 3-méthacryloxypropyltriméthoxysilane, 3-méthacryloxypropyltris(méthoxyéthoxy)silane, 3-méthoxypropyltriméthoxysilane, N-méthylaminopropyltriméthoxysilane, carbamate d'O-4-méthylcoumarinyl-N-[3-(triéthoxysilyl)propyle], 7-oct-1-ényl-triméthoxysilane, N-phénéthyl-N'-triéthoxysilylpropylurée, N-phénylaminopropyltriméthoxysilane, 3-(N-styrylméthyl-2-aminoéthylamino)propyltriméthoxysilane, 3-thiocyanatopropyltriéthoxysilane, N-(3-triéthoxysilylpropyl)acétylglycinamide, N-(triéthoxysilylpropyl)dansylamide, N-[3-(triéthoxysilyl)propyl]-2,4-dinitrophénylamine, carbamate de triéthoxysilylpropyléthyle, N-[3-(triéthoxysilyl)propyl]-4,5-dihydroimidazole, N-triéthoxysilylpropyl-o-menthocarbamate, 3-(triéthoxysilyl-propyl)-p-nitrobenzamide, acide N-[3-(triéthoxysilyl)-propyl]phtalmique, urée de N-(triéthoxysilylopropyle),phényléthane de 1-triméthoxysilyl-2-(p,m-chlorométhyle), azoture de 2-(triméthoxysilyl)éthylphénylsulfonyle, β-triméthoxysilyl-éthyl-2-pyridine, bromure de triméthoxysilyloctyltriméthylammonium, cinnamate de triméthoxysilylpropyle, chlorure de N-(3-triméthoxysilylpropyl)-N-méthyl-N,N-diallylammonium, triméthoxysilylpropyldiéthylènetriamine, sel trisodique de l'acide N-[(3-triméthoxysilyl)propyl]éthylènediaminetriacétique, chlorure de triméthoxysilylpropylisothiouronium, N-(3-triméthoxysilylpropyl)pyrrole, bromure de N-triméthoxysilylpropyl-tri-N-butylammonium, chlorure de N-triméthoxysilylpropyl-N,N,N-triméthylammonium, vinyltriéthoxysilane, vinyltriisopropoxysilane, vinyltriméthoxysilane, vinyl-tris-t-butoxysilane, vinyl-tris(2-méthoxyéthoxy)silane, vinyl-triisopropénoxysilane, vinyltris-(t-butylperoxy)silane, 2-acétoxyéthyltrichlorosilane, 3-acryloxypropyltrichlorosilane, allyltrichlorosilane, 8-bromooctyltrichlorosilane, bromophényltrichlorosilane, 3-bromopropyltrichlorosilane, 2-(carbométhoxy)éthyltrichlorosilane, 1-chloroéthyltrichlorosilane, 2-chloroéthyltrichlorosilane, p-(chlorométhyl)phényltrichlorosilane, chlorométhyltrichlorosilane, chlorophényltrichlorosilane, 3-chloropropyltrichlorosilane, 2-(4-chlorosulfonylphényl)éthyltrichlorosilane, (3-cyanobutyl)trichlorosilane, 2-cyanoéthyltrichlorosilane, 3-cyanopropyltrichlorosilane, (dichlorométhyl)trichlorosilane, (dichlorophényl)trichlorosilane, 6-hex-1-ényl-trichlorosilane, 3-méthacryloxypropyltrichlorosilane, 3-(4-méthoxyphényl)propyltrichlorosilane, 7-oct-1-ényl-trichlorosilane, 3-(N-phtalimido)propyltrichlorosilane, 1-trichlorosilyl-2-(p,m-chlorométhylphényl)éthane, 4-[2-(trichlorosilyl)éthyl]cyclohexène, 2-[2-(trichlorosilyl)éthyl]pyridine, 4-[2-(trichlorosilyl)éthyl]pyridine, chloroformiate de 3-(trichlorosilyl)propyle et vinyltrichlorosilane.

11. Feuille métallique selon l'une quelconque des revendications 1 à 8, dans laquelle ledit agent de couplage du type silane est au moins un composé représenté par la formule 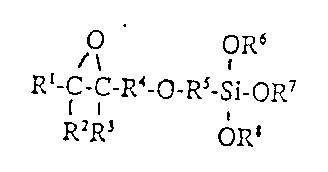 dans laquelle
R¹, R² et R³ sont chacun, indépendamment les uns des autres, l'hydrogène ou des groupes hydrocarbures ;
R⁴ et R⁵ sont chacun, indépendamment l'un de l'autre, des groupes hydrocarbures,
R⁶, R⁷ et R⁸ représentant chacun, indépendamment les uns des autres, des groupes hydrocarbures.

12. Feuille métallique selon l'une quelconque des revendications 1 à 8, dans laquelle ledit agent de couplage du type silane est au moins un composé représenté par la formule 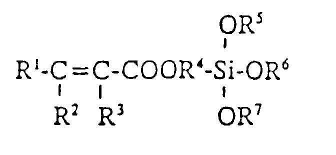 dans laquelle
R¹, R² et R³ sont chacun, indépendamment les uns des autres, l'hydrogène ou des groupes hydrocarbures ;
R⁴ est un groupe alkylène ou alkylidène ; et
R⁵, R⁶ et R⁷ sont chacun, indépendamment les uns des autres, des groupes hydrocarbures.

13. Feuille métallique selon l'une quelconque des revendications 1 à 8, dans laquelle ledit agent de couplage du type silane est au moins un composé représenté par la formule 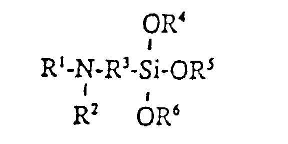 dans laquelle
R¹ et R² sont chacun, indépendamment l'un de l'autre, l'hydrogène ou des groupes hydrocarbures ;
R³ est un groupe alkylène ou alkylidène ; et
R⁴, R⁵ et R⁶ sont chacun, indépendamment les uns des autres, des groupes hydrocarbyle.

14. Feuille métallique selon l'une quelconque des revendications 1 à 8, dans laquelle ledit agent de couplage du type silane est au moins un composé représenté par la formule 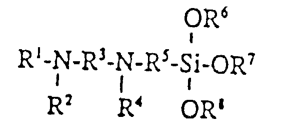 dans laquelle
R¹, R² et R⁴ sont chacun, indépendamment les uns des l'autre, l'hydrogène ou des groupes hydrocarbures ;
R³ et R⁵ sont, indépendamment l'un de l'autre, des groupes alkylène ou alkylidène ; et
R⁶, R⁷ et R⁸ sont chacun, indépendamment les uns des autres, des groupes hydrocarbures.

15. Feuille métallique selon l'une quelconque des revendications 1 à 8, dans laquelle ledit agent de couplage du type silane est au moins un composé représenté par la formule 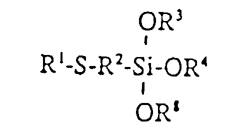 dans laquelle
R¹ est l'hydrogène ou un groupe hydrocarbure ;
R² est un groupe alkylène ou alkylidène ; et
R³, R⁴ et R⁵ sont chacun, indépendamment les uns des autres, des groupes hydrocarbures.

16. Feuille métallique selon l'une quelconque des revendications 1 à 8, dans laquelle ledit agent de couplage du type silane est au moins un composé représenté par la formule 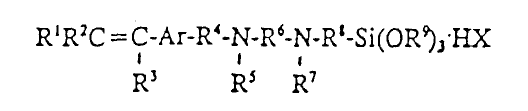 dans laquelle
R¹, R², R³, R⁵ et R⁷ sont chacun, indépendamment les uns des autres, l'hydrogène ou des groupes hydrocarbures ;
R⁴, R⁶ et R⁸ sont chacun, indépendamment les uns des autres, des groupes alkylène ou alkylidène ; et
chaque R⁹ est indépendamment un groupe hydrocarbure ;
Ar est un groupe aromatique ; et
X est un halogène.

17. Feuille métallique selon l'une quelconque des revendications 1 à 8, dans laquelle ledit agent de couplage du type silane est au moins un composé représenté par la formule 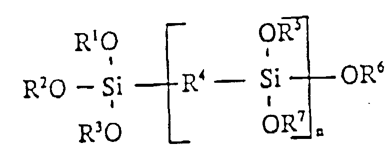 dans laquelle
R¹, R², R³, R⁵, R⁶ et R⁷ sont chacun, indépendamment les uns des autres, des groupes hydrocarbures ;
R⁴ est un groupe alkylène ou alkylidène ; et
n vaut 0 ou 1.

18. Feuille métallique selon l'une quelconque des revendications 1 à 8, dans laquelle ledit agent de couplage du type silane est choisi parmi les aminopropyltriméthoxysilane, tétraéthoxysilane, bis(2-hydroxyéthyl)-3-aminopropyltriéthoxysilane, 3-(N-styrylméthyl-2-aminoéthylamine)propyltriméthoxysilane, 3-glycidoxypropyltriméthoxysilane, N-méthylaminopropyltriméthoxysilane, 2-(2-aminoéthyl-3-aminopropyl)triméthoxysilane et N-phénylaminopropyltriméthoxysilane.

19. Feuille métallique selon l'une quelconque des revendications 1 à 8, dans laquelle ledit agent de couplage du type silane est un mélange d'agents de couplage silanes, ledit mélange étant :
(A) 3-glycidoxypropyltriméthoxysilane et phényltriéthoxysilane ;
(B) N-méthylaminopropyltriméthoxysilane et chloropropyltriméthoxysilane ;
(C) 3-(N-styrylméthyl-2-aminoéthylamino)propyltriméthoxysilane et N-méthylaminopropyltriméthoxysilane; ou
(D) 3-glycidoxypropyltriméthoxysilane et N-méthylaminopropyltriméthoxysilane.

20. Feuille métallique selon l'une quelconque des revendications précédentes, dans laquelle au moins une couche métallique est située entre l'un desdits côtés de ladite feuille métallique et ladite couche favorisant l'adhérence, le métal dans ladite couche métallique étant choisi parmi l'indium, l'étain, le nickel, le cobalt, le laiton, le bronze ou un mélange d'au moins deux de ceux-ci.

21. Feuille métallique selon l'une quelconque des revendications 1 à 19, dans laquelle au moins une couche métallique est située entre l'un desdits côtés de ladite feuille métallique et ladite couche favorisant l'adhérence, le métal dans ladite couche métallique étant choisi parmi l'étain, un mélange de chrome et de zinc, le nickel, le molybdène, l'aluminium et des mélanges d'au moins deux de ceux-ci.

22. Feuille métallique selon l'une quelconque des revendications 1 à 19, dans laquelle au moins une première couche métallique est collée sur ledit côté de ladite feuille métallique, le métal dans ladite première couche métallique étant choisi parmi l'indium, l'étain, le nickel, le cobalt, le laiton et le bronze, au moins une seconde couche métallique est collée sur ladite première couche métallique, le métal dans ladite seconde couche métallique étant choisi parmi l'étain, le chrome, un mélange de chrome et de zinc, le zinc, le nickel, le molybdène, l'aluminium et des mélanges d'au moins deux de ceux-ci, et ladite couche favorisant l'adhérence est collée sur ladite seconde couche métallique.

23. Feuille métallique selon la revendication 1, ayant un côté mat et un côté brillant, et la couche favorisant l'adhérence recouvrant ledit côté brillant, ledit côté brillant étant non traité ou étant traité avec au moins une couche métallique constituée d'indium, d'étain, de laiton, de bronze, de molybdène, d'aluminium ou d'un mélange d'au moins deux de ceux-ci, ladite couche favorisant l'adhérence étant collée sur ledit côté brillant non traité ou sur ladite couche métallique.

24. Feuille métallique selon la revendication 1, dans laquelle la surface de base de ladite feuille métallique, qui est située au-dessous de ladite couche favorisant l'adhérence, a au moins une couche métallique collée sur celle-ci, le métal dans ladite couche métallique étant choisi parmi l'indium, l'étain, le laiton, le bronze ou un mélange d'au moins deux de ceux-ci, ladite couche favorisant l'adhérence étant collée sur ladite couche métallique, et ladite feuille métallique est une feuille de cuivre déposée par électrolyse.

25. Feuille métallique selon la revendication 1, dans laquelle la surface de base de ladite feuille métallique, qui est située au-dessous de ladite couche favorisant l'adhérence, a au moins une couche métallique collée sur celle-ci, le métal dans ladite couche métallique étant choisi parmi l'étain, le molybdène, l'aluminium et des mélanges d'au moins deux de ceux-ci, ladite couche favorisant l'adhérence étant collée sur ladite couche métallique, et ladite feuille métallique est une feuille de cuivre déposée par électrolyse.

26. Feuille métallique selon la revendication 1, dans laquelle la surface de base de ladite feuille métallique, qui est située au-dessous de ladite couche favorisant l'adhérence, a au moins une première couche métallique collée sur ladite surface de base, le métal dans ladite première couche métallique étant choisi parmi l'indium, l'étain, le nickel, le cobalt, le laiton et le bronze, et au moins une seconde couche métallique est collée sur ladite première couche métallique, le métal dans ladite seconde couche métallique étant choisi parmi l'étain, le zinc, le nickel, le molybdène, l'aluminium et des mélanges d'au moins deux de ceux-ci, ladite couche favorisant l'adhérence étant collée sur ladite seconde couche métallique, et la feuille métallique est une feuille de cuivre déposée par électrolyse.

27. Feuille métallique selon la revendication 1, ayant une surface extra-plate avec une rugosité superficielle Rₜₘ d'environ 7 micromètres ou moins sur au moins un côté de ladite feuille métallique et une couche favorisant l'adhérence qui recouvre ledit côté de ladite feuille métallique, la surface de base de ladite feuille métallique étant non traitée ou traitée avec au moins une couche métallique constituée d'indium, d'étain, de laiton, de bronze, de molybdène, d'aluminium ou d'un mélange d'au moins deux de ceux-ci, ladite couche favorisant l'adhérence étant collée sur ledit côté non traité de ladite couche métallique, et la feuille métallique étant une feuille de cuivre déposée par électrolyse.

28. Feuille métallique selon la revendication 1, comprenant, en outre, une couche de matériau non électroconducteur qui recouvre la couche favorisant l'adhérence.
